# EUROPEAN PATENT APPLICATION

(11) **EP 4 648 106 A1**
(43) Date of publication of application: **12.11.2025**
(21) Application number: 25165935.5
(22) Date of filing: 25.03.2025
(51) Int. Cl.: H01L 23/528, H01L 21/768, H10D 30/40, H10D 88/00

(54) **THREE-DIMENSIONAL SEMICONDUCTOR DEVICE AND METHOD OF FABRICATING THE SAME**

(30) Priority: 07.05.2024 KR 20240060074
(71) Applicant: Samsung Electronics Co., Ltd., Suwon-si, Gyeonggi-do 16677 (KR)
(72) Inventor: NOH, Changwoo, 16677 Suwon-si (KR); PARK, Sungil, 16677 Suwon-si (KR); PARK, Jae Hyun, 16677 Suwon-si (KR)
(74) Representative: Marks & Clerk LLP

(57) **Abstract**

A three-dimensional semiconductor device may include a first active region, which includes a first channel pattern and a first source/drain pattern connected to each other, on a substrate, a second active region, which includes a second channel pattern and a second source/drain pattern connected to each other, on the first active region, a gate electrode on the first and second channel patterns, a bottom active contact electrically connected to the first source/drain pattern and extended from the first source/drain pattern in a first direction, a lower metal layer provided below the bottom active contact, the lower metal layer including bottom via patterns and bottom interconnection lines electrically connected to the bottom active contact, and a division structure electrically connected to at least one of the bottom via patterns. The division structure may include a division liner pattern and a connection metal pattern penetrating the same.

## Description

### TECHNICAL FIELD

The present invention relates to a three-dimensional semiconductor device.

### BACKGROUND

A semiconductor device includes an integrated circuit composed of metal-oxide-semiconductor field-effect transistors (MOS-FETs). To meet an increasing demand for a semiconductor device with a small pattern size and a reduced design rule, the MOS-FETs are being aggressively scaled down. The scale-down of the MOS-FETs may lead to deterioration in operational properties of the semiconductor device. A variety of studies are conducted to overcome technical limitations caused by the scale-down of the semiconductor device and to provide a high performance semiconductor device.

### SUMMARY

According to the present invention, there is provided a three-dimensional semiconductor device according to claim 1. Preferred embodiments are defined by the dependent claims.

In general, in some aspects, the present disclosure is directed toward a three-dimensional semiconductor device with a high integration density and/or improved reliability, and a method of fabricating a three-dimensional semiconductor device with a high integration density and/or improved reliability.

According to some implementations, the present disclosure is directed to a three-dimensional semiconductor device that includes a first active region on a substrate, the first active region including a first channel pattern and a first source/drain pattern connected to the first channel pattern, a second active region stacked on the first active region, the second active region including a second channel pattern and a second source/drain pattern connected to the second channel pattern, a gate electrode on the first channel pattern and the second channel pattern, a bottom active contact electrically connected to the first source/drain pattern, the bottom active contact having a bar shape extending from the first source/drain pattern in a first direction, a lower metal layer provided below the bottom active contact, the lower metal layer including bottom via patterns and bottom interconnection lines electrically connected to the bottom active contact, and a division structure electrically connected to at least one of the bottom via patterns. The division structure may include a division liner pattern and a connection metal pattern penetrating the division liner pattern.

According to some implementations, the present disclosure is directed to a three-dimensional semiconductor device that includes a substrate including an insulating pattern, a device isolation layer defining the insulating pattern, a division structure extended in a first direction to cross the insulating pattern, a lower metal layer provided below the substrate, the lower metal layer including a bottom via pattern and a bottom interconnection line, and a first metal layer on the division structure, the first metal layer including an upper via pattern and an upper interconnection line. The division structure may include a connection metal pattern and a division liner pattern provided on a side surface of the connection metal pattern to enclose the connection metal pattern. The bottom interconnection line, the bottom via pattern, the connection metal pattern, the upper via pattern, and the upper interconnection line may be electrically connected to each other.

According to some implementations, the present disclosure is directed to a three-dimensional semiconductor device that includes a first active region on a substrate, the first active region including a first channel pattern and a first source/drain pattern connected to the first channel pattern, a dummy region stacked on the first active region, the dummy region including a dummy pattern on the first channel pattern and an interlayer insulating layer on the first source/drain pattern, a second active region stacked on the dummy region, the second active region including a second channel pattern and a second source/drain pattern connected to the second channel pattern, a gate electrode on the first channel pattern and the second channel pattern, a bottom active contact electrically connected to the first source/drain pattern, a lower metal layer provided below the bottom active contact, the lower metal layer including bottom via patterns and bottom interconnection lines electrically connected to the bottom active contact, an upper active contact electrically connected to the second source/drain pattern, and a division structure electrically connected to at least one of the bottom via patterns. The division structure may include a division liner pattern and a connection metal pattern penetrating the division liner pattern, and the connection metal pattern may be in direct contact with the first and second source/drain patterns.

Preferably, an apparatus (e.g., device, package, chip or integrated circuit) may comprise a plurality of single height or logic cells (a single height cell may be a logic cell) each comprising any three-dimensional semiconductor device disclosed herein such as according to any of the above implementation(s). Each such cell may have a portion comprising a logic circuit having active regions. Each active region may comprise at least one transistor, e.g., a field-effect transistor such as a MOS-FET, comprising a source/drain pattern, channel pattern and gate electrode. For example, a first active region of the cell, portion or circuit may comprise at least one NMOS-FET and a corresponding/complementary second active region of the cell, portion or circuit may comprise at least one PMOS-FET, or vice-versa. Thus, the cell, portion or circuit may include complementary active regions each comprising at least one transistor (e.g., the active regions having respective and complementary N-type and P-type FET(s)) and may further include at least one interconnection line connecting such complementary transistor(s) of respective active regions to each other. Specifically, the interconnection lines may connect source/drain patterns of complementary (n-type and p-type) transistors together. In the apparatus, each cell, portion, circuit and/or pair of complementary active regions may be separated from a neighbouring cell, portion, circuit and/or active region pair by a division structure that may be according to any division structure described herein. The division structure may be, or be provided at, each boundary between each pair of adjacent cells of a said apparatus. In this regard, source/drain regions of complementary transistors of an active region pair may be connected to each other through such a division structure. Additionally or alternatively, the division structure may comprise an insulating material and be separated from a gate electrode of the cell, portion or circuit. Any one or more of the features of this paragraph may be found in any implementation as described herein and which has one or more three-dimensional device(s) as defined by the claims.

### BRIEF DESCRIPTION OF THE DRAWINGS

Example implementations will be more clearly understood from the following detailed description, taken in conjunction with the accompanying drawings.
FIGS. 1 and 2 are diagrams illustrating examples of a logic cell of a semiconductor device according to some implementations.
FIGS. 3A and 3B are plan views illustrating examples of a three-dimensional semiconductor device according to some implementations.
FIGS. 4A to 4E are sectional views taken along lines A-A', B-B', C-C', D-D', and E-E', respectively, of FIG. 3A, according to some implementations.
FIGS. 5A to 5C are sectional views illustrating examples of the three-dimensional semiconductor device of FIG. 4A according to some implementations.
FIGS. 6A to 6C are sectional views taken along the lines A-A', B-B', and E-E', respectively, of FIG. 3A, according to some implementations.
FIGS. 7A to 25E are sectional views illustrating an example of a method of fabricating a three-dimensional semiconductor device according to some implementations.

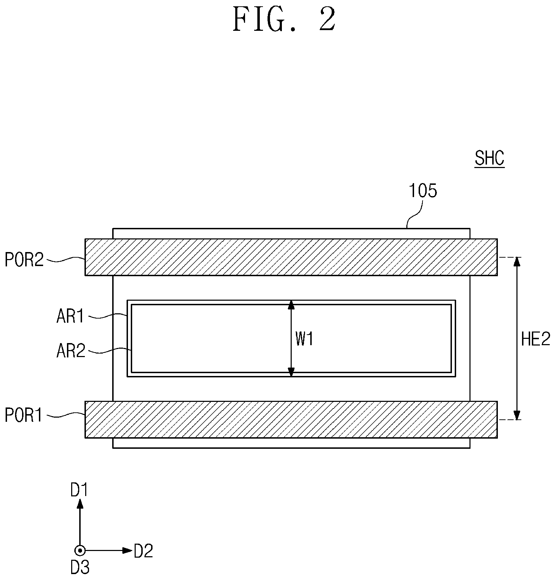

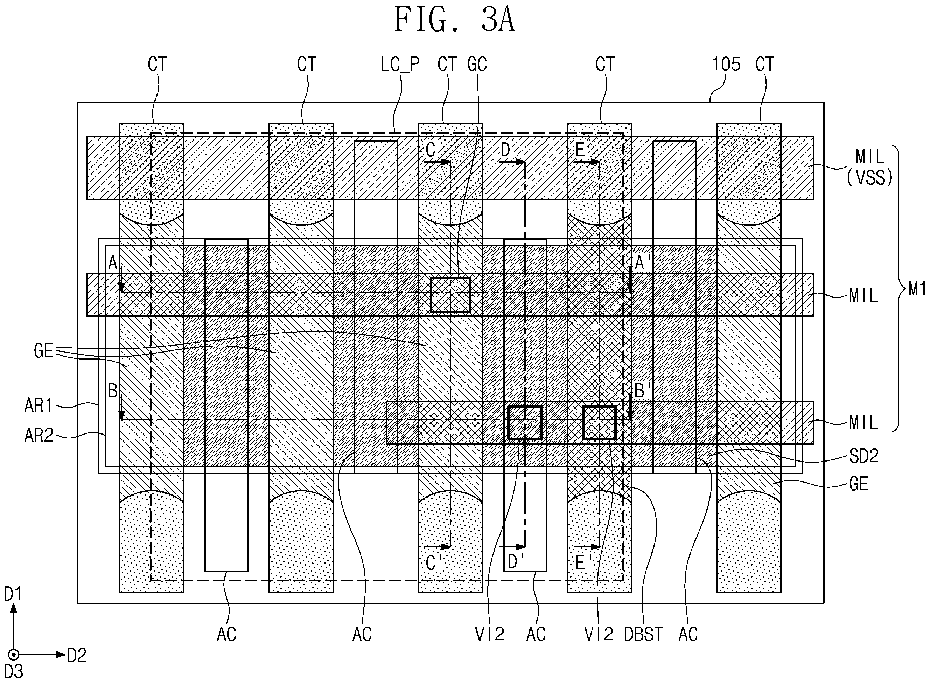

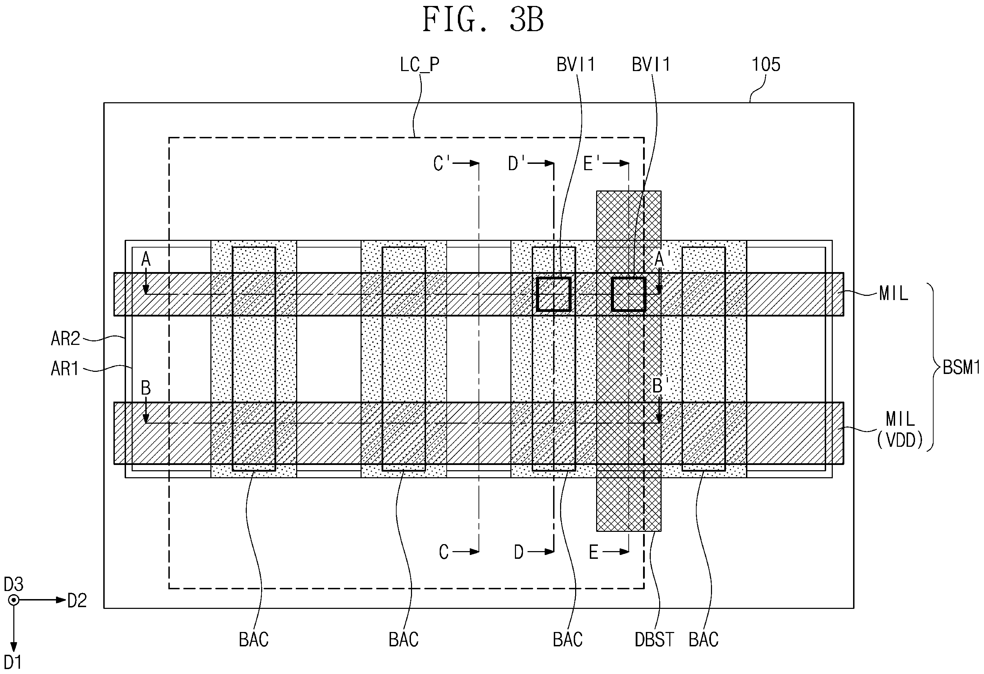

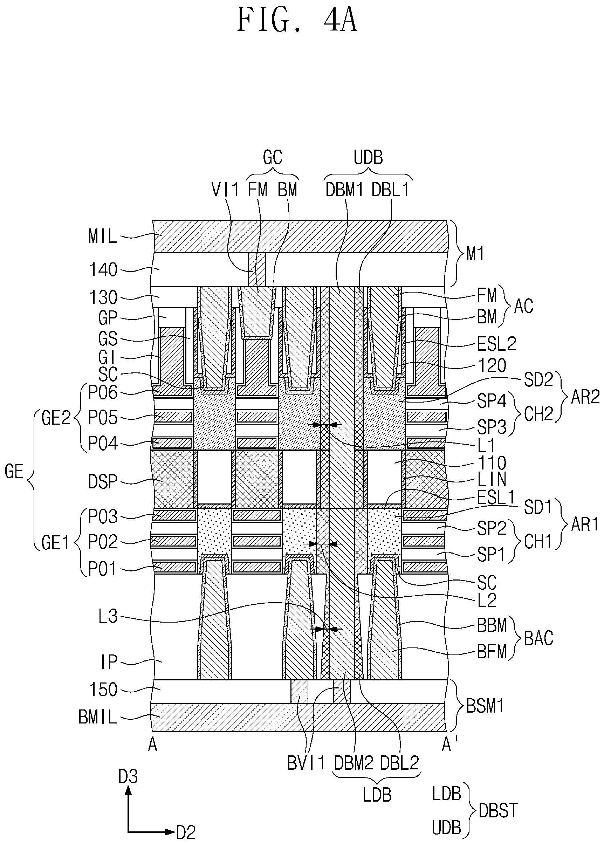

It is further noted that the three-dimensional semiconductor device of FIGS. 3A and 3B and 4A to 4E may be a detailed example of a portion of the single height cell of FIG. 2.

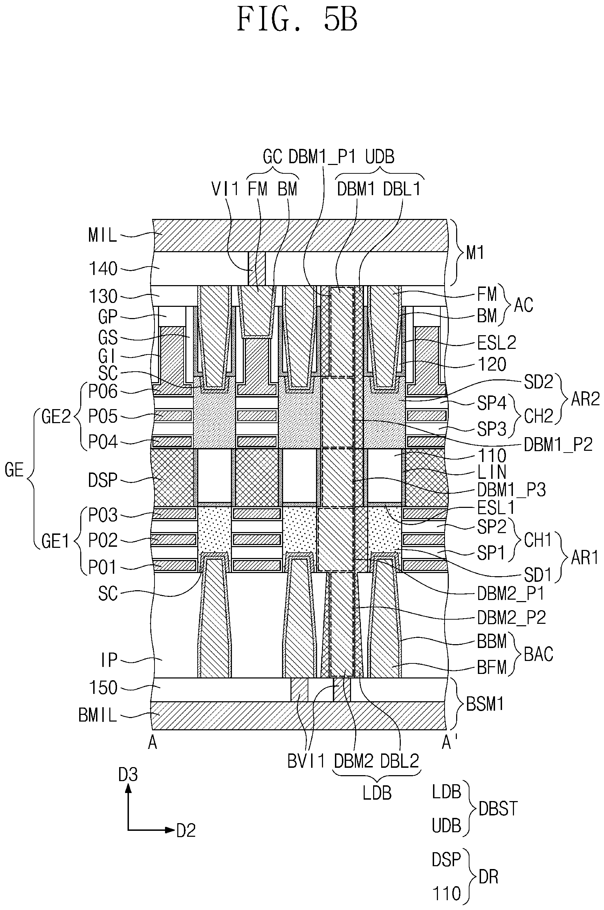

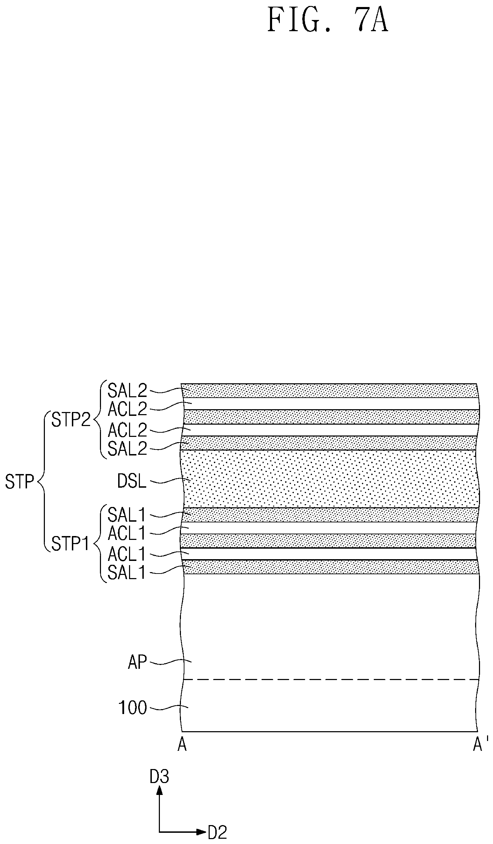

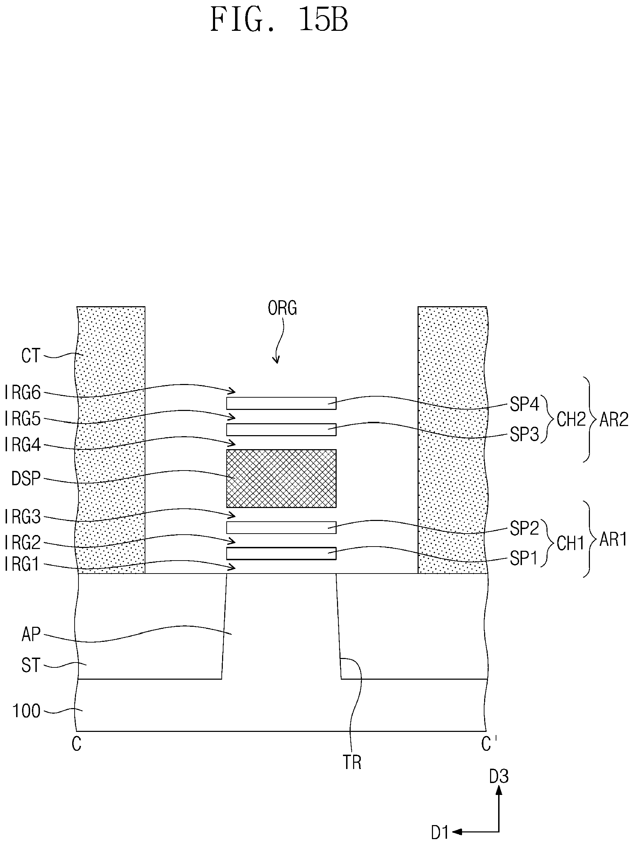

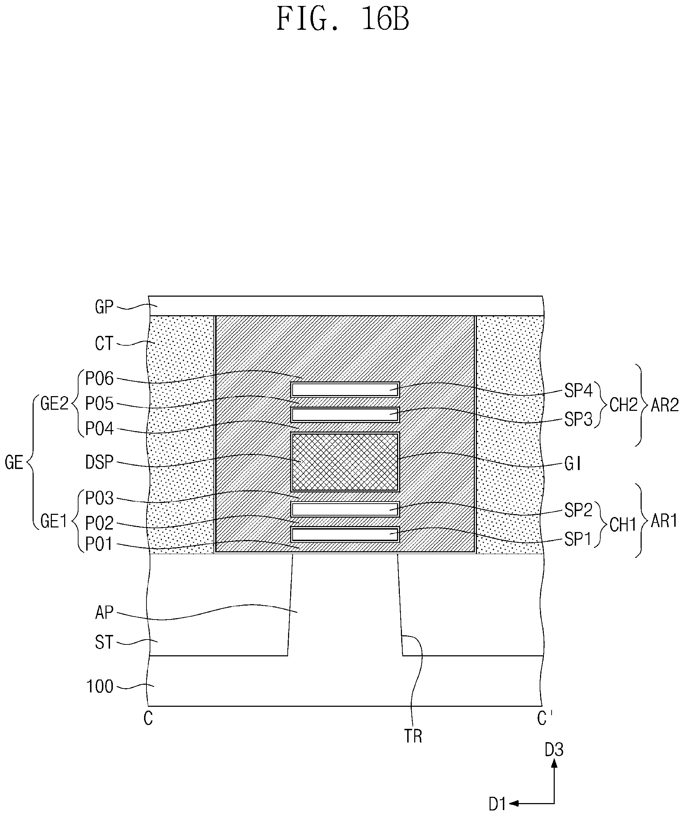

Furthermore, FIGS. 7A, 8A, 9A, 10A, 11A, 12A, 13A, 14A, 15A, 16A, 17A, 18A, 19A, 20A, 21A, 22A, 23A, 24A, and 25A are sectional views corresponding to the line A-A' of FIG. 3A. FIGS. 15B, 18B, 19B, 20B, and 23B are sectional views corresponding to the line B-B' of FIG. 3A. FIGS. 5B, 6B, 7B, 10B, 11B, 12, 13B, 14B, 15C, 18C, 19C, 20C, and 23C are sectional views corresponding to the line C-C' of FIG. 3A. FIGS. 7C, 8B, 9B, 15D, 18D, 19D, 20D, and 23D are sectional views corresponding to the line D-D' of FIG. 3A. FIGS. 16B, 17B, 18E, 19E, 20E, 21B, 22B, and 23E are sectional views corresponding to the line E-E' of FIG. 3A.

### DETAILED DESCRIPTION

The present disclosure relates to a three-dimensional semiconductor device, and in particular, to a three-dimensional semiconductor device including field effect transistors.

Hereinafter, example implementations will be explained in detail with reference to the accompanying drawings.

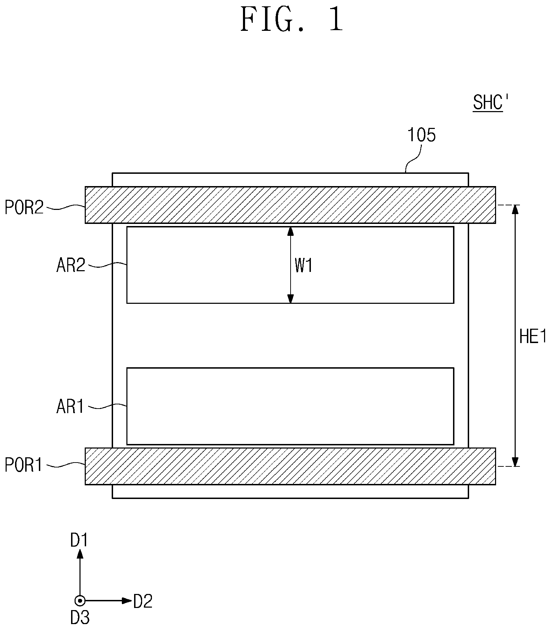

FIG. 1 is a diagram illustrating an example of a logic cell of a two-dimensional semiconductor device. In FIG. 1, a single height cell SHC' may be provided. In detail, a first power line POR1 and a second power line POR2 may be provided on a substrate 105. A drain voltage VDD (e.g., a power voltage) may be applied to one of the first and second power lines POR1 and POR2. A source voltage VSS (e.g., a ground voltage) may be applied to the other of the first and second power lines POR1 and POR2. The source voltage VSS may be applied to the first power line POR1, and the drain voltage VDD may be applied to the second power line POR2.

The single height cell SHC' may be defined between the first power line POR1 and the second power line POR2. The single height cell SHC' may include a first active region AR1 and a second active region AR2. One of the first and second active regions AR1 and AR2 may be a PMOS-FET region, and the other of the first and second active regions AR1 and AR2 may be an NMOS-FET region. For example, the first active region AR1 may be an NMOS-FET region, and the second active region AR2 may be a PMOS-FET region. That is, the single height cell SHC' may include a CMOS structure that is provided between the first and second power lines POR1 and POR2.

In some arrangements corresponding to Fig. 1, the semiconductor device may be a two-dimensional device, in which transistors of a front-end-of-line (FEOL) layer are two-dimensionally arranged. For example, NMOS-FETs of the first active region AR1 and PMOS-FETs of the second active region AR2 may be formed to be spaced apart from each other in a first direction D1.

Each of the first and second active regions AR1 and AR2 may have a first width W1 in the first direction D1. In FIG. 1, a length of the single height cell SHC' in the first direction D1 may be defined as a first height HE1. The first height HE1 may be substantially equal to a distance (e.g., pitch) between the first and second power lines POR1 and POR2.

The single height cell SHC' may constitute a single logic cell. In the present disclosure, the logic cell may mean a logic device (e.g., AND, OR, XOR, XNOR, inverter, and so forth), which is configured to execute a specific function. In other words, the logic cell may include transistors constituting the logic device and interconnection lines connecting the transistors to each other.

In FIG. 1, since the single height cell SHC' includes a two-dimensional device, the first and second active regions AR1 and AR2 may not be overlapped with each other and may be spaced apart from each other in the first direction D1. Accordingly, the first height HE1 of the single height cell SHC' should be defined to span both the first and second active regions AR1 and AR2, which are spaced apart from each other in the first direction D1. As a result, the first height HE1 of the single height cell SHC' in the comparative example may have a relatively increased value. That is, the single height cell SHC' in the comparative example may have a relatively large area.

FIG. 2 is a diagram illustrating an example of a logic cell of a three-dimensional semiconductor device according to some implementations. In FIG. 2, a single height cell SHC, which includes a three-dimensional device with stacked transistors, may be provided. In detail, a first power line POR1 and a second power line POR2 may be provided on a substrate 105. The single height cell SHC may be defined between the first power line POR1 and the second power line POR2.

The single height cell SHC may include first and second active regions AR1 and AR2. One of the first and second active regions AR1 and AR2 may be a PMOS-FET region, and the other of the first and second active regions AR1 and AR2 may be an NMOS-FET region.

In some implementations, the semiconductor device may be a three-dimensional device, in which transistors preferably of a FEOL layer are vertically stacked. The first active region AR1 as a bottom tier may be provided on the substrate 105, and the second active region AR2 as a top tier may be stacked on the first active region AR1. For example, the NMOS-FETs of the first active region AR1 may be provided on the substrate 105, and the PMOS-FETs of the second active region AR2 may be stacked on the NMOS-FETs. The first active region AR1 and the second active region AR2 may be spaced apart from each other in a vertical direction (i.e., a third direction D3).

Each of the first and second active regions AR1 and AR2 may have a first width W1 in a first direction D1. In some implementations, a length of the single height cell SHC in the first direction D1 may be defined as a second height HE2.

Since the single height cell SHC includes the three-dimensional device (i.e., the stacked transistors), the first active region AR1 may be overlapped with the second active region AR2. Accordingly, the second height HE2 of the single height cell SHC may have a size spanning a single active region or may be larger than the first width W1. As a result, the second height HE2 of the single height cell SHC according to the present embodiment may be smaller than the first height HE1 of the single height cell SHC' of FIG. 1 described above. In other words, the single height cell SHC may have a relatively small area. This may make it possible to increase an integration density of the three-dimensional semiconductor device.

FIGS. 3A and 3B are plan views illustrating examples of a three-dimensional semiconductor device according to some implementations. FIG. 3A is a frontside plan view of the three-dimensional semiconductor device, and FIG. 3B is a backside plan view of the three-dimensional semiconductor device. FIGS. 4A to 4E are sectional views taken along lines A-A', B-B', C-C', D-D' and E-E', respectively, of FIG. 3A according to some implementations. The three-dimensional semiconductor device of FIGS. 3A and 3B and 4A to 4E may be a detailed example of a portion of the single height cell of FIG. 2.

In FIG. 3A, the substrate 105 may be provided, and here, a portion LC_P of a logic cell constituting a logic circuit may be disposed in the substrate 105. The substrate 105 may be an insulating substrate including an insulating material. In some implementations, the substrate 105 may be a semiconductor substrate that is formed of or includes silicon, germanium, silicon germanium, a compound semiconductor material, or the like.

A portion of the single height cell SHC previously described with reference to FIG. 2 may be provided in the portion LC_P of the logic cell. In other words, a division structure DBST may be disposed in the portion LC_P of the logic cell to separate the vertically-stacked transistors (preferably of the FEOL layer; noting that any reference herein to 'vertical' does not imply any particularly orientation of a device, 'vertical' generally being merely relative to, e.g., on or over, a substrate) and adjacent ones of the single height cells SHC from each other. The adjacent ones of the single height cells SHC may be adjacent to each other in a second direction D2.

Hereinafter, the portion LC_P of the logic cell in the three-dimensional semiconductor device will be described in more detail with reference to FIGS. 3A, 3B, and 4A to 4E. The single height cell SHC, which is the logic cell, may include the first and second active regions AR1 and AR2, which are sequentially stacked on the substrate 105. One of the first and second active regions AR1 and AR2 may be a PMOS-FET region, and the other of the first and second active regions AR1 and AR2 may be an NMOS-FET region. The first active region AR1 may be provided as a bottom tier of the preferably FEOL layer, and the second active region AR2 may be provided as a top tier of the preferably FEOL layer. The NMOS- and PMOS-FETs of the first and second active regions AR1 and AR2 may be vertically stacked to form a three-dimensional stack transistor. In some implementations, the first active region AR1 may be a PMOS-FET region, and the second active region AR2 may be an NMOS-FET region.

An insulating pattern IP may be defined by a trench TR that is formed in the substrate 105. The insulating pattern IP may be a vertically-protruding portion of the substrate 105. When viewed in a plan view, the insulating pattern IP may be a bar-shaped pattern that is extended in the second direction D2. The first and second active regions AR1 and AR2 described above may be sequentially stacked on the insulating pattern IP. The insulating pattern IP may include at least one of insulating materials (e.g., silicon oxide, silicon nitride, or silicon oxynitride).

A device isolation layer ST may be provided to fill the trench TR. The device isolation layer ST may include a silicon oxide layer. A top surface of the device isolation layer ST may be coplanar with or lower than a top surface of the insulating pattern IP. The device isolation layer ST may not cover a first channel pattern CH1 and a second channel pattern CH2, which will be described below.

The first active region AR1, which includes first channel patterns CH1 and first source/drain patterns SD1, may be provided on the insulating pattern IP. The first channel pattern CH1 may be interposed between a pair of the first source/drain patterns SD1. The first channel pattern CH1 may connect the pair of the first source/drain patterns SD1 to each other.

The first channel pattern CH1 may include a first semiconductor pattern SP1 and a second semiconductor pattern SP2, which are stacked to be spaced apart from each other. Each of the first and second semiconductor patterns SP1 and SP2 may be formed of or include at least one of silicon (Si), germanium (Ge), or silicon germanium (SiGe). In some implementations, each of the first and second semiconductor patterns SP1 and SP2 may be formed of or include crystalline silicon.

The first source/drain patterns SD1 may be provided on the top surface of the insulating pattern IP. Each of the first source/drain patterns SD1 may be an epitaxial pattern, which is formed by a selective epitaxial growth (SEG) process. In some implementations, a top surface of the first source/drain pattern SD1 may be higher than a top surface of the second semiconductor pattern SP2 of the first channel pattern CH1.

The first source/drain patterns SD1 may be doped with impurities to have a first conductivity type. The first conductivity type may be an n-type or a p-type. In some implementations, the first conductivity type may be a p-type. The first source/drain patterns SD1 may include silicon germanium (SiGe) and/or silicon (Si).

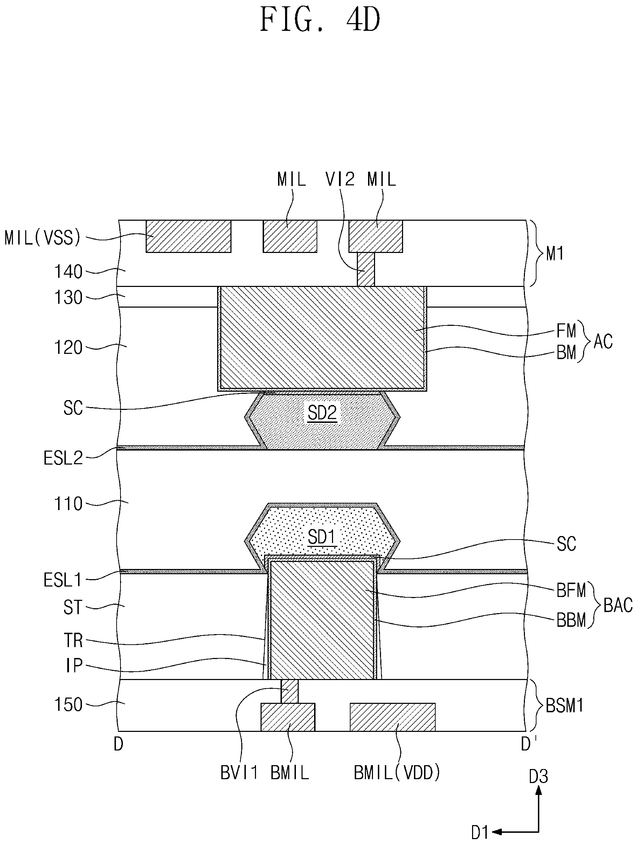

A first etch stop layer ESL1 may be provided on the first source/drain patterns SD1 (e.g., see FIG. 4D). A first interlayer insulating layer 110 may be provided on the first etch stop layer ESL1. The first interlayer insulating layer 110 may cover the first source/drain patterns SD1.

A second interlayer insulating layer 120 and the second active region AR2 may be provided on the first interlayer insulating layer 110. The second active region AR2 may include second channel patterns CH2 and second source/drain patterns SD2. The second channel patterns CH2 may be vertically overlapped with the first channel patterns CH1, respectively. The second source/drain patterns SD2 may be vertically overlapped with the first source/drain patterns SD1, respectively. The second channel pattern CH2 may be interposed between a pair of the second source/drain patterns SD2. The second channel pattern CH2 may connect the pair of the second source/drain patterns SD2 to each other.

The second channel pattern CH2 may include a third semiconductor pattern SP3 and a fourth semiconductor pattern SP4, which are stacked to be spaced apart from each other. The third and fourth semiconductor patterns SP3 and SP4 of the second channel pattern CH2 may include the same semiconductor material as the first and second semiconductor patterns SP1 and SP2 of the first channel pattern CH1 described above.

At least one dummy pattern DSP may be interposed between the first channel pattern CH1 and the second channel pattern CH2 thereon. The dummy pattern DSP may be spaced apart from the first and second source/drain patterns SD1 and SD2. In other words, the dummy pattern DSP may not be connected to any source/drain pattern. The dummy pattern DSP may be formed of or include at least one of semiconductor materials (e.g., silicon (Si), germanium (Ge) or silicon germanium (SiGe)) or silicon-based insulating materials (e.g., silicon oxide or silicon nitride). In some implementations, the dummy pattern DSP may include the silicon-based insulating material.

The second source/drain patterns SD2 may be provided on a top surface of the first interlayer insulating layer 110. A second etch stop layer ESL2 may be provided on the second source/drain patterns SD2 (e.g., see FIG. 4D). The second interlayer insulating layer 120 may be provided on the second etch stop layer ESL2. The second interlayer insulating layer 120 may cover the second source/drain patterns SD2.

Each of the second source/drain patterns SD2 may be an epitaxial pattern, which is formed by a selective epitaxial growth (SEG) process. In some implementations, a top surface of the second source/drain pattern SD2 may be higher than a top surface of the fourth semiconductor pattern SP4 of the second channel pattern CH2.

The second source/drain patterns SD2 may be doped with impurities to have a second conductivity type. The second conductivity type may be different from the first conductivity type of the first source/drain pattern SD1. For example, the second conductivity type may be an n-type. The second source/drain patterns SD2 may be formed of or include silicon (Si) and/or silicon germanium (SiGe).

The second interlayer insulating layer 120 and a third interlayer insulating layer 130 may be provided on the second etch stop layer ESL2. The second interlayer insulating layer 120 may cover the second source/drain patterns SD2. A top surface of the third interlayer insulating layer 130 may be coplanar with a top surface of each of upper active contacts AC, which will be described below.

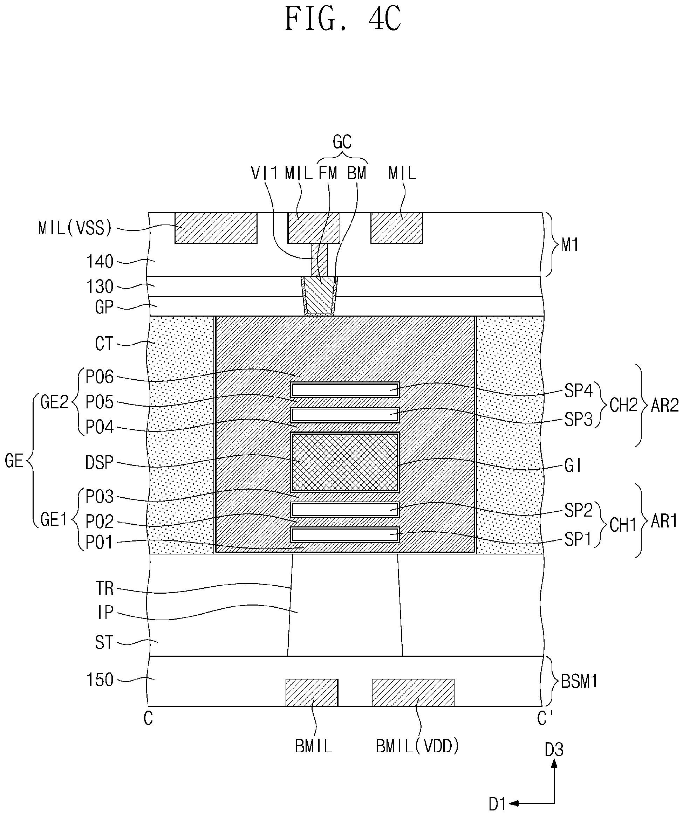

A gate electrode GE may be provided on the first and second channel patterns CH1 and CH2 that are stacked (e.g., see FIG. 4C). When viewed in a plan view, the gate electrode GE may be a bar-shaped pattern that is extended in the first direction D1. The gate electrode GE may be vertically overlapped with the first and second channel patterns CH1 and CH2.

The gate electrode GE may be extended from the top surface of the device isolation layer ST (or the top surface of the insulating pattern IP) to a gate capping pattern GP in a vertical direction (i.e., the third direction D3). The gate electrode GE may be extended from the first channel pattern CH1 of the first active region AR1 to the second channel pattern CH2 of the second active region AR2 in the third direction D3. The gate electrode GE may be extended from the lowermost semiconductor pattern (i.e., the first semiconductor pattern SP1) to the uppermost semiconductor pattern (i.e., the fourth semiconductor pattern SP4) in the third direction D3.

The gate electrode GE may be provided on top, bottom, and opposite side surfaces of each of the first to fourth semiconductor patterns SP1 to SP4. In other words, the transistor may be a three-dimensional field effect transistor (e.g., MBCFET or GAAFET), in which the gate electrode GE is provided to three-dimensionally surround the channel pattern.

The gate electrode GE may include a first gate electrode GE1, which is provided in the bottom tier (i.e., the first active region AR1) of the preferably FEOL layer, and a second gate electrode GE2, which is provided in the top tier (i.e., the second active region AR2) of the preferably FEOL layer. The first and second gate electrodes GE1 and GE2 may be overlapped with each other, when viewed in a plan view. The first and second gate electrodes GE1 and GE2 may be connected to each other. That is, the gate electrode GE according to the present embodiment may be a common gate electrode, in which connecting the first gate electrode GE1 on the first channel pattern CH1 and the second gate electrode GE2 on the second channel pattern CH2 are connected to each other.

The first gate electrode GE1 may include a first inner electrode PO1 interposed between the insulating pattern IP and the first semiconductor pattern SP1, a second inner electrode PO2 interposed between the first semiconductor pattern SP1 and the second semiconductor pattern SP2, and a third inner electrode PO3 interposed between the second semiconductor pattern SP2 and the dummy pattern DSP.

The second gate electrode GE2 may include a fourth inner electrode PO4 interposed between the dummy pattern DSP and the third semiconductor pattern SP3, a fifth inner electrode PO5 interposed between the third semiconductor pattern SP3 and the fourth semiconductor pattern SP4, and an outer electrode PO6 on the fourth semiconductor pattern SP4.

A pair of gate spacers GS may be respectively disposed on opposite side surfaces of the gate electrode GE. In FIG. 4A, the pair of the gate spacers GS may be disposed on opposite side surfaces of the outer electrode PO6, respectively. The gate spacers GS may be extended along the gate electrode GE and in the first direction D1. Top surfaces of the gate spacers GS may be higher than a top surface of the gate electrode GE. The top surfaces of the gate spacers GS may be coplanar with a top surface of the second interlayer insulating layer 120. The gate spacers GS may be formed of or include at least one of SiCN, SiCON, or SiN. In some implementations, the gate spacers GS may be a multi-layered structure, which includes at least two different materials selected from SiCN, SiCON, and SiN.

The gate capping pattern GP may be provided on the top surface of the gate electrode GE. The gate capping pattern GP may be extended along the gate electrode GE or in the first direction D1. In some implementations, the gate capping pattern GP may be formed of or include at least one of SiON, SiCN, SiCON, or SiN. The second etch stop layer ESL2 may be provided on a side surface of the gate spacer GS.

A gate insulating layer GI may be interposed between the gate electrode GE and the first to fourth semiconductor patterns SP1 to SP4. The gate insulating layer GI may include a silicon oxide layer, a silicon oxynitride layer, and/or a high-k dielectric layer. In some implementations, the gate insulating layer GI may include a silicon oxide layer, which is formed to directly cover the semiconductor patterns SP1 to SP4, and a high-k dielectric layer, which is formed on the silicon oxide layer. In other words, the gate insulating layer GI may be a multi-layered structure including the silicon oxide layer and the high-k dielectric layer.

The high-k dielectric layer may be formed of or include at least one of high-k dielectric materials whose dielectric constants are higher than that of silicon oxide. For example, the high-k dielectric material may include at least one of hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, or lead zinc niobate.

The gate electrode GE may include a first metal pattern and a second metal pattern on the first metal pattern. The first metal pattern may be provided on the gate insulating layer GI and may be adjacent to the first to fourth semiconductor patterns SP1, SP2, SP3, and SP4. The first metal pattern may include a work-function metal, which can be used to adjust a threshold voltage of the transistor. By adjusting a thickness and composition of the first metal pattern, it may be possible to realize a transistor having a desired threshold voltage. For example, the first to third inner electrodes PO1, PO2, and PO3 of the first gate electrode GE1 and the fourth and fifth inner electrodes PO4 and PO5 of the second gate electrode GE2 may be composed of the first metal pattern, which is the work function metal. In some implementations, the work function metal in the first to third inner electrodes PO1, PO2, and PO3 of the first gate electrode GE1 may be of a different material than the work function metal in the fourth and fifth inner electrodes PO4 and PO5 of the second gate electrode GE2.

The first metal pattern may include a metal nitride layer. For example, the first metal pattern may include at least one metallic material, which is selected from the group consisting of titanium (Ti), tantalum (Ta), aluminum (Al), tungsten (W) and molybdenum (Mo), and nitrogen (N). In some implementations, the first metal pattern may further include carbon (C). The first metal pattern may include a plurality of work function metal layers which are stacked.

The second metal pattern may be formed of or include a metallic material whose resistance is lower than the first metal pattern. For example, the second metal pattern may include at least one metallic material, which is selected from the group consisting of tungsten (W), aluminum (Al), titanium (Ti), and tantalum (Ta). For example, the outer electrode PO6 of the second gate electrode GE2 may include the first metal pattern and the second metal pattern on the first metal pattern.

A cutting pattern CT may be provided to penetrate the gate electrode GE. The gate electrodes GE, which are adjacent to each other in the first direction D1, may be separated from each other by the cutting pattern CT. For example, referring to FIG. 4C, a pair of cutting patterns CT may be respectively provided at opposite end portions of the gate electrode GE. The cutting pattern CT may be formed of or include at least one of insulating materials (e.g., silicon oxide, silicon nitride, or combinations thereof).

The third interlayer insulating layer 130 may be provided on the gate capping pattern GP, the cutting pattern CT, and the second interlayer insulating layer 120. A gate contact GC may be provided to penetrate the third interlayer insulating layer 130 and the gate capping pattern GP and to be electrically connected to the gate electrode GE. The gate contact GC may be freely disposed on the gate electrode GE, without any limitation in its position, when viewed in a plan view.

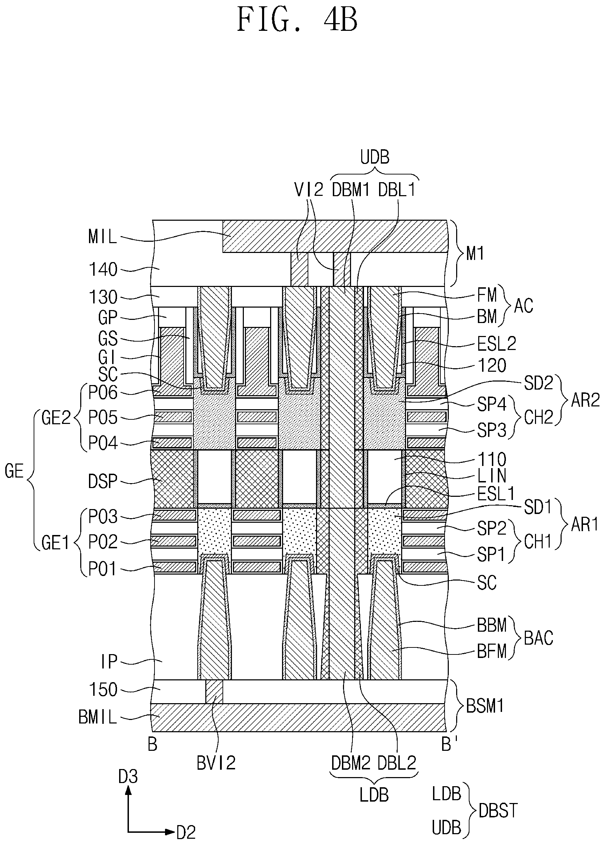

The upper active contacts AC may be provided to be electrically connected to the second source/drain patterns SD2, respectively. For example, referring to FIGS. 4A and 4B, the upper active contact AC may be provided to penetrate the third interlayer insulating layer 130, the second interlayer insulating layer 120, and the second etch stop layer ESL2 and may be directly connected to the second source/drain pattern SD2. In some implementations, a pair of the upper active contacts AC may be respectively provided at both sides of the gate electrode GE. When viewed in a plan view, the upper active contact AC may be a bar-shaped pattern that is extended in the first direction D1.

The upper active contact AC may be a self-aligned contact. For example, the upper active contact AC may be formed by a self-alignment process using the gate capping pattern GP and the gate spacer GS. For example, the upper active contact AC may cover at least a portion of the side surface of the gate spacer GS. The upper active contact AC may cover a portion of a top surface of the gate capping pattern GP.

A metal-semiconductor compound layer SC (e.g., a silicide layer) may be interposed between the upper active contact AC and the second source/drain pattern SD2. The upper active contact AC may be electrically connected to the second source/drain pattern SD2 through the metal-semiconductor compound layer SC. For example, the metal-semiconductor compound layer SC may be formed of or include at least one of titanium silicide, tantalum silicide, tungsten silicide, nickel silicide, or cobalt silicide.

Each of the upper active contact AC and the gate contact GC may include a conductive pattern FM and a barrier pattern BM enclosing the conductive pattern FM. For example, the conductive pattern FM may be formed of or include at least one of metallic materials (e.g., aluminum, copper, tungsten, molybdenum, and cobalt). The barrier pattern BM may be provided to cover side and bottom surfaces of the conductive pattern FM. In some implementations, the barrier pattern BM may include a metal layer and a metal nitride layer. The metal layer may be formed of or include at least one of titanium, tantalum, tungsten, nickel, cobalt, or platinum. The metal nitride layer may be formed of or include at least one of titanium nitride (TiN), tantalum nitride (TaN), tungsten nitride (WN), nickel nitride (NiN), cobalt nitride (CoN), or platinum nitride (PtN).

Bottom active contacts BAC may be provided to be electrically connected to the first source/drain patterns SD1, respectively. For example, referring to FIGS. 4A and 4B, the bottom active contact BAC may be provided to penetrate the insulating pattern IP and may be directly connected to the first source/drain pattern SD1. In some implementations, a pair of the bottom active contacts BAC may be respectively provided at both sides of the gate electrode GE. When viewed in a plan view, the bottom active contact BAC may be a bar-shaped pattern that is extended in the first direction D1.

The metal-semiconductor compound layer SC (e.g., a silicide layer) may be interposed between the bottom active contact BAC and the first source/drain pattern SD1. The bottom active contact BAC may be electrically connected to the first source/drain pattern SD1 through the metal-semiconductor compound layer SC. For example, the metal-semiconductor compound layer SC may be formed of or include at least one of titanium silicide, tantalum silicide, tungsten silicide, nickel silicide, or cobalt silicide.

The bottom active contact BAC may include a bottom conductive pattern BFM and a bottom barrier pattern BBM enclosing the bottom conductive pattern BFM. For example, the bottom conductive pattern BFM may be formed of or include at least one of metallic materials (e.g., aluminum, copper, tungsten, molybdenum, and cobalt). The bottom barrier pattern BBM may cover side and top surfaces of the bottom conductive pattern BFM. The bottom barrier pattern BBM may include a metal layer and/or a metal nitride layer. The metal layer may be formed of or include at least one of titanium, tantalum, tungsten, nickel, cobalt, or platinum. The metal nitride layer may be formed of or include at least one of titanium nitride (TiN), tantalum nitride (TaN), tungsten nitride (WN), nickel nitride (NiN), cobalt nitride (CoN), or platinum nitride (PtN). The bottom conductive pattern BFM may be formed of or include the same material as the conductive pattern FM, and the bottom barrier pattern BBM may be formed of or include the same material as the barrier pattern BM.

The division structure DBST may be provided at boundaries between adjacent ones of the single height cells or adjacent ones of the logic cells. The division structure DBST may be extended in the first direction D1 to be parallel to the gate electrodes GE (e.g., see FIG. 3A). A pitch between the division structure DBST and the gate electrode GE, which are adjacent to each other, may be equal to a pitch between the gate electrodes GE.

The division structure DBST may penetrate the first to third interlayer insulating layers 110, 120, and 130 and may be extended into the insulating pattern IP. For example, the division structure DBST may be provided to penetrate the first to third interlayer insulating layers 110, 120, and 130 and the insulating pattern IP. The division structure DBST may include a division liner pattern and a connection metal pattern penetrating the division liner pattern. In other words, the division liner pattern may be provided on a side surface of the connection metal pattern to enclose or surround the connection metal pattern.

The division liner pattern may include a first division liner pattern DBL1 and a second division liner pattern DBL2, and the connection metal pattern may include a first connection metal pattern DBM1 and a second connection metal pattern DBM2.

The division structure DBST may include a lower division structure LDB, which is provided in the insulating pattern IP and the first active region AR1, and an upper division structure UDB, which is provided in the first to third interlayer insulating layers 110, 120, and 130 and the second active region AR2. The upper division structure UDB may be provided on the lower division structure LDB. For example, the upper division structure UDB may include the first division liner pattern DBL1 and the first connection metal pattern DBM1 penetrating the first division liner pattern DBL1, and the lower division structure LDB may include the second division liner pattern DBL2 and the second connection metal pattern DBM2 penetrating the second division liner pattern DBL2.

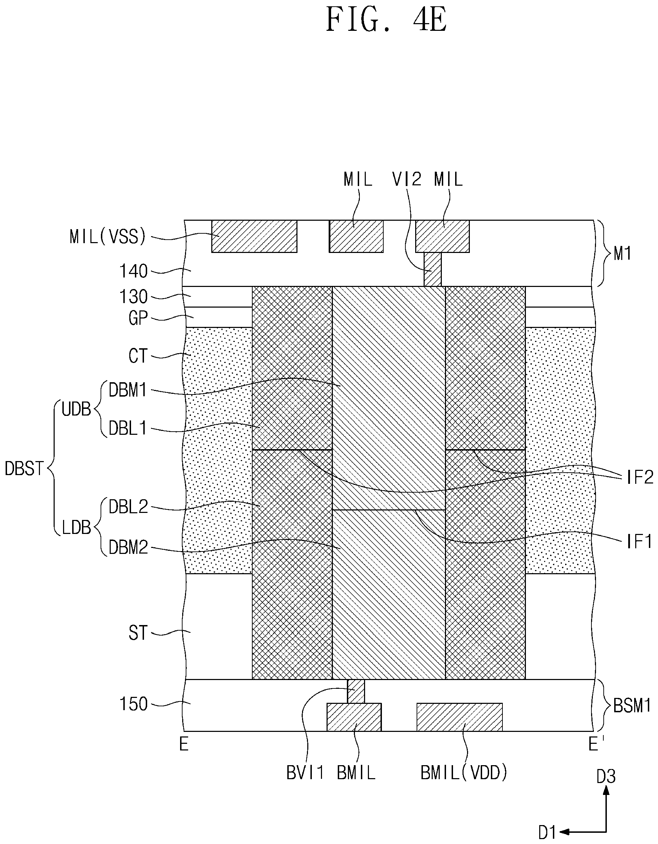

In FIG. 4E, the first division liner pattern DBL1 may be in direct contact with the second division liner pattern DBL2, and the first connection metal pattern DBM1 may be in direct contact with the second connection metal pattern DBM2. A first interface IF1 between the first and second connection metal patterns DBM1 and DBM2 may be located at a level lower than a second interface IF2 between the first and second division liner patterns DBL1 and DBL2, when measured in the third direction D3. In some implementations, at least one of the first and second interfaces IF1 and IF2 may not be observable or measurable. This is because the first and second division liner patterns DBL1 and DBL2 include the same material and the first and second connection metal patterns DBM1 and DBM2 include the same material.

The cutting pattern CT may be provided on the device isolation layer ST and may be provided on opposite side surfaces of the division structure DBST. For example, the cutting pattern CT may be provided on side surfaces of the first and second division liner patterns DBL1 and DBL2. A top surface of the cutting pattern CT may be located at a level lower than a top surface of the division structure DBST in the third direction D3. The top surface of the division structure DBST may be located at the same level as the top surface of the third interlayer insulating layer 130, and a bottom surface of the division structure DBST may be located at the same level as the bottom surface of the device isolation layer ST, when measured in the third direction D3.

In FIGS. 4A and 4B, the first and second division liner patterns DBL1 and DBL2 may horizontally separate the upper active contact AC, the bottom active contact BAC, and the first and second source/drain patterns SD1 and SD2 from the first and second connection metal patterns DBM1 and DBM2. The first and second division liner patterns DBL1 and DBL2 may include at least one of insulating materials (e.g., silicon oxide, silicon nitride, or silicon oxynitride). In some implementations, the first and second division liner patterns DBL1 and DBL2 may be formed of or include silicon nitride.

The first division liner pattern DBL1 may have a first thickness L1 in the second direction D2. The second division liner pattern DBL2 may include a first portion, which is adjacent to the first source/drain pattern SD1, and a second portion, which is disposed below the first portion and is adjacent to the insulating pattern IP. When measured in the second direction D2, the first and second portions of the second division liner pattern DBL2 may have second and third thicknesses L2 and L3, respectively.

Each of the first and second thicknesses L1 and L2 may be substantially constant. The third thickness L3 may increase as a distance to a lower metal layer BSM1 to be described below decreases. The second thickness L2 may be larger than the first thickness L1 and the third thickness L3. This is because a width of each of the first gate electrode GE1 and the first channel pattern CH1 in the first active region AR1 in the second direction D2 is larger than a width of each of the second gate electrode GE2 and the second channel pattern CH2 in the second active region AR2 in the second direction D2. That is, since the division structure DBST is formed in the first and second active regions AR1 and AR2 on a border of the logic cell to correspond to the widths, the second thickness L2 may be larger than the first and third thicknesses L1 and L3. The smallest value of the third thickness L3 may be smaller than the first thickness L1, and the largest value of the third thickness L3 may be equal to the first thickness L1.

The first and second connection metal patterns DBM1 and DBM2 may be electrically connected to a first metal layer M1, which will be described below, and the lower metal layer BSM1. The first and second connection metal patterns DBM1 and DBM2 may be formed of or include at least one of metallic materials (e.g., aluminum, copper, tungsten, molybdenum, or cobalt). In some implementations, the first and second connection metal patterns DBM1 and DBM2 may be formed of or include molybdenum or cobalt.

A fourth interlayer insulating layer 140 may be provided on the third interlayer insulating layer 130, the gate contact GC, the upper active contact AC, and the division structure DBST. A first metal layer M1 may be provided in the fourth interlayer insulating layer 140. The first metal layer M1 may include upper via patterns VI1 and VI2, upper interconnection lines MIL and the first and second power lines POR1 and POR2. The upper via patterns VI1 and VI2, the upper interconnection lines MIL, and the first and second power lines POR1 and POR2 may be formed of or include at least one of metallic materials (e.g., copper (Cu), aluminum (Al), ruthenium (Ru), cobalt (Co), tungsten (W), and molybdenum (Mo)). In an embodiment, the upper interconnection lines MIL in the fourth interlayer insulating layer 140 may be used as an interconnection line for applying the source voltage.

In some implementations, the gate contact GC may be directly connected to the upper interconnection line MIL through the first upper via pattern VI1. The upper active contact AC may be connected to the upper interconnection line MIL through the second upper via pattern VI2. The division structure DBST may be connected to the upper interconnection line MIL through the second upper via pattern VI2. In other words, the division structure DBST may be electrically connected to the second source/drain pattern SD2 through the second upper via pattern VI2 and the upper interconnection line MIL.

Additional metal layers (e.g., M2, M3, M4, and so forth) may be stacked on the first metal layer M1. The first metal layer M1 and the additional metal layers (e.g., M2, M3, M4, and so forth) thereon may constitute a back-end-of-line (BEOL) layer of the semiconductor device. The additional metal layers (e.g., M2, M3, M4, and so forth) on the first metal layer M1 may include routing lines, which are used to connect the logic cells to each other.

A fifth interlayer insulating layer 150 may be provided on a bottom surface of the substrate 105. The lower metal layer BSM1 may be provided in the fifth interlayer insulating layer 150. The lower metal layer BSM1 may include bottom via patterns BVI1 and BVI2 and bottom interconnection lines BMIL. The bottom via patterns BVI1 and BVI2 and the bottom interconnection lines BMIL may be formed of or include at least one of metallic materials (e.g., copper (Cu), aluminum (Al), ruthenium (Ru), cobalt (Co), tungsten (W), and molybdenum (Mo)). In an embodiment, the bottom interconnection lines BMIL in the fifth interlayer insulating layer 150 may be used as an interconnection line for applying the drain voltage.

In some implementations, the bottom active contact BAC may be directly connected to the bottom interconnection line BMIL through the first and second bottom via patterns BVI1 and BVI2. The division structure DBST may be connected to the bottom interconnection line BMIL through the first bottom via pattern BVI1. In other words, the division structure DBST may be electrically connected to the first source/drain pattern SD1 through the first lower via pattern BVI1 and the bottom interconnection line BMIL.

In FIG. 4E, the division structure DBST may be electrically connected to the first and second source/drain patterns SD1 and SD2. For example, the division structure DBST may be electrically connected to the first and second source/drain patterns SD1 and SD2 through the bottom interconnection line BMIL, the first bottom via pattern BVI1, first and second connection metal pattern DBM1, DBM2, the second upper via pattern VI2, and the upper interconnection line MIL.

In a three-dimensional semiconductor device, in some implementations, source/drain regions of vertically-stacked transistors may be connected to each other through a division structure (e.g., a single diffusion break (SDB)), and in this case, it may be possible to prevent an over-head phenomenon caused by a connection pattern for connecting the source/drain regions. In other words, it may be possible to reduce an occupying area of the connection pattern in the logic cell. Accordingly, an effective area of the logic cell may be reduced, and an integration density of the three-dimensional semiconductor device may be increased.

In addition, the connection pattern may produce a parasitic capacitance in relation to a neighboring gate electrode. This is because a distance between the connection pattern and the gate electrode is relatively small and the connection pattern is formed of a conductive material. However, according to some implementations, since the division structure includes an insulating material and is separated from the gate electrode by a sufficient distance (e.g., a gate-to-gate pitch), it may be possible to reduce a parasitic capacitance issue. Accordingly, the reliability of the three-dimensional semiconductor device may be improved.

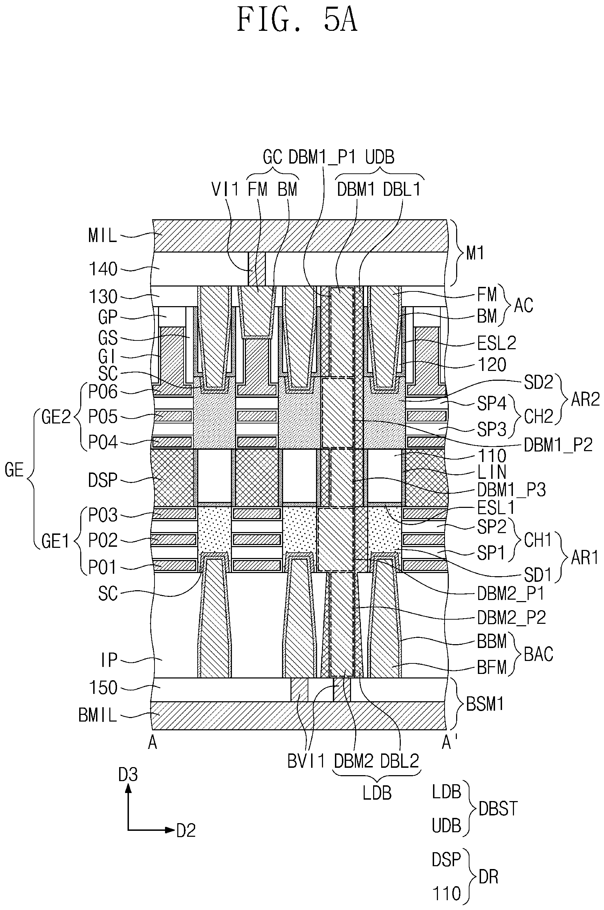

Hereinafter, an example of a three-dimensional semiconductor device will be described in more detail with reference to FIGS. 5A to 5C. FIGS. 5A to 5C may correspond to a modified example of the embodiment of FIG. 4A. In the following description, a previously-described element may be identified by the same reference number without repeating an overlapping description thereof, for concise description.

The single height cell SHC, which is the logic cell, may include a first active region AR1, a dummy region DR, and a second active region AR2, which are sequentially stacked on the substrate 105. One of the first and second active regions AR1 and AR2 may be a PMOS-FET region, and the other of the first and second active regions AR1 and AR2 may be an NMOS-FET region. The first active region AR1 may be provided as a bottom tier of the preferably FEOL layer, and the second active region AR2 may be provided as a top tier of the preferably FEOL layer. The NMOS-FET and PMOS-FET of the first and second active regions AR1 and AR2 may be vertically stacked to form a three-dimensional stack transistor.

The dummy region DR may include the dummy pattern DSP, which is interposed between the first channel pattern CH1 and the second channel pattern CH2, and the first interlayer insulating layer 110, which is interposed between the first source/drain pattern SD1 and the second source/drain pattern SD2.

The division structure DBST may include a division liner pattern and a connection metal pattern penetrating the division liner pattern. The division liner pattern may include the first division liner pattern DBL1 and the second division liner pattern DBL2, and the connection metal pattern may include the first connection metal pattern DBM1 and the second connection metal pattern DBM2.

The division structure DBST may include the lower division structure LDB, which is provided in the insulating pattern IP and the first active region AR1, and the upper division structure UDB, which is provided in the first to third interlayer insulating layers 110, 120, and 130 and the second active region AR2. The upper division structure UDB may be provided on the lower division structure LDB. For example, the upper division structure UDB may include the first division liner pattern DBL1 and the first connection metal pattern DBM1 penetrating the first division liner pattern DBL1, and the lower division structure LDB may include the second division liner pattern DBL2 and the second connection metal pattern DBM2 penetrating the second division liner pattern DBL2.

In FIG. 5A, the first connection metal pattern DBM1 of the upper division structure UDB may include a first part DBM1_P1, which is provided between the first division liner patterns DBL1, a second part DBM1_P2, which is in direct contact with the second source/drain pattern SD2, and a third part DBM1_P3, which is provided between dummy patterns DSP.

The first division liner pattern DBL1 may be provided on a side surface of the second part DBM1_P2, and the second source/drain pattern SD2 may be provided on an opposite side surface of the second part DBM1_P2. In other words, the second part DBM1_P2 of the first connection metal pattern DBM1 may be in direct contact with the second source/drain pattern SD2. Since the first division liner pattern DBL1 is not disposed on the side surface of the second part DBM1_P2, a width of the second part DBM1_P2 in the second direction D2 may be larger than a width of each of the first and third parts DBM1_P1 and DBM1_P3 in the second direction D2.

The second connection metal pattern DBM2 of the lower division structure LDB may include a fourth part DBM2_P1, which is in direct contact with the first source/drain pattern SD1, and a fifth part DBM2_P2, which is provided between the second division liner patterns DBL2.

The second division liner pattern DBL2 may be provided on a side surface of the fourth part DBM2_P1, and the first source/drain pattern SD1 may be provided on an opposite side surface of the fourth part DBM2_P1. In other words, the fourth part DBM2_P1 of the second connection metal pattern DBM2 may be in direct contact with the first source/drain pattern SD1. Since the second division liner pattern DBL2 is not disposed on the side surface of the fourth part DBM2_P1, a width of the fourth part DBM2 _P1 in the second direction D2 may be larger than a width of the fifth part DBM2_P2 in the second direction D2. The width of the fourth part DBM2_P1 in the second direction D2 may be larger than a width of the second part DBM1_P2 in the second direction D2.

In FIG. 5B, a liner layer LIN may be provided on a side surface of the third part DBM1_P3, and the dummy pattern DSP may be provided on an opposite side surface of the third part DBM1_P3. In this case, a width of the second part DBM1_P2 in the second direction D2 may be substantially equal to a width of the third part DBM1_P3 in the second direction D2.

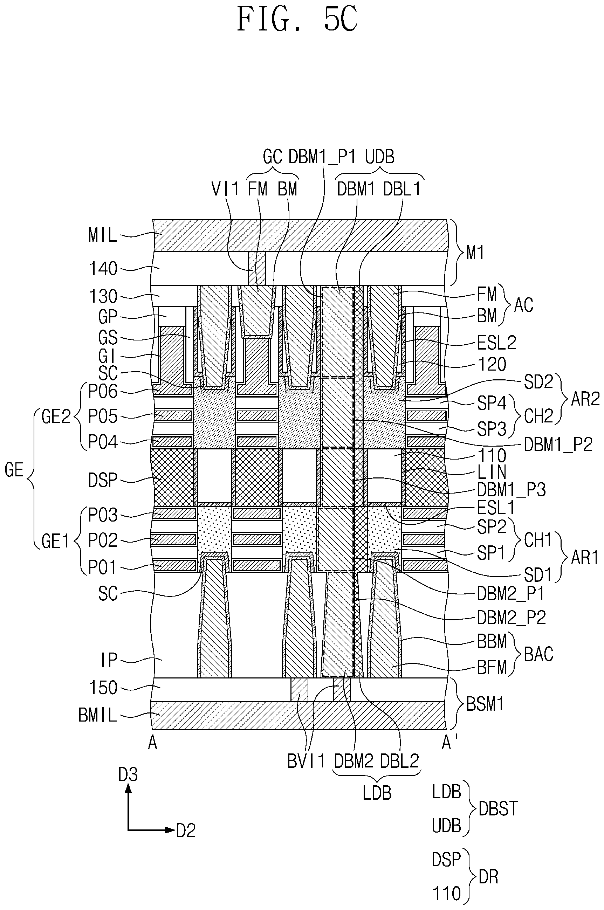

In FIG. 5C, a division liner pattern may be provided on only side surfaces of the first and second connection metal patterns DBM1 and DBM2. For example, the first division liner pattern DBL1 may be provided on only the side surface of the first connection metal pattern DBM1, and the second division liner pattern DBL2 may be provided on only the side surface of the second connection metal pattern DBM2. The second etch stop layer ESL2, the second source/drain pattern SD2, and the liner layer LIN may be provided on an opposite side surface of the first connection metal pattern DBM1. The first source/drain pattern SD1 and the insulating pattern IP may be provided on an opposite side surface of the second connection metal pattern DBM2.

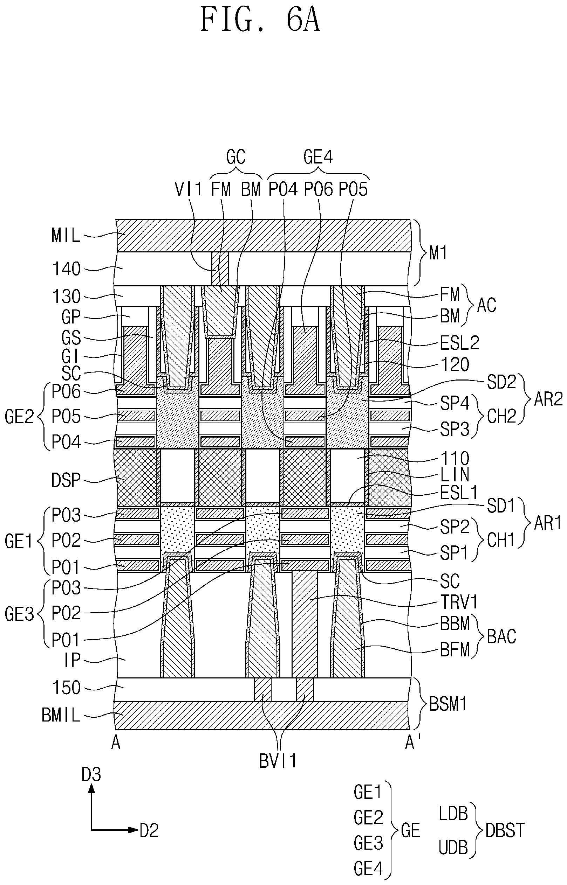

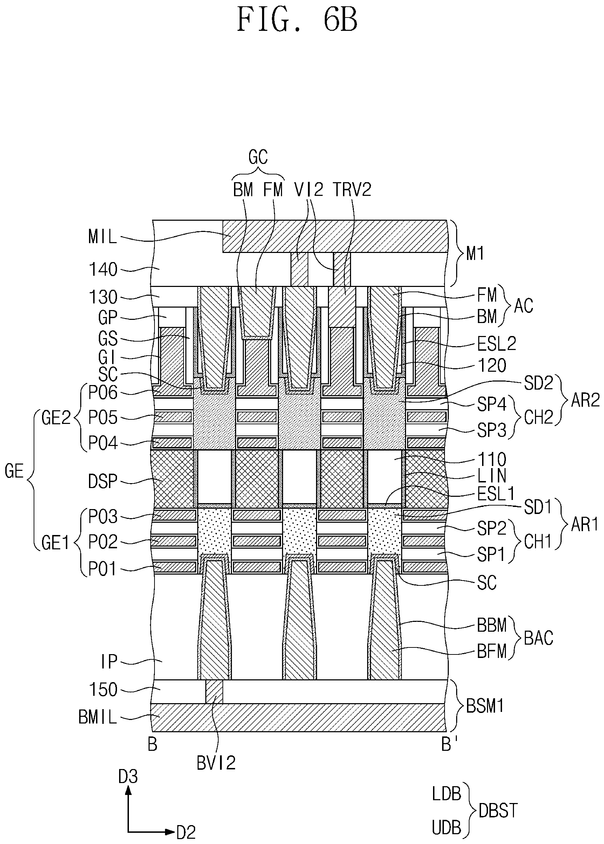

Hereinafter, a three-dimensional semiconductor device will be described in more detail with reference to FIGS. 6A to 6C. In the following description, a previously-described element may be identified by the same reference number without repeating an overlapping description thereof, for concise description.

The single height cell SHC, which is the logic cell, may include the first and second active regions AR1 and AR2, which are sequentially stacked on the substrate 105. One of the first and second active regions AR1 and AR2 may be a PMOS-FET region, and the other of the first and second active regions AR1 and AR2 may be an NMOS-FET region. The first active region AR1 may be provided as a bottom tier of the preferably FEOL layer, and the second active region AR2 may be provided as a top tier of the preferably FEOL layer. The NMOS-FET and PMOS-FET of the first and second active regions AR1 and AR2 may be vertically stacked to form a three-dimensional stack transistor.

The first gate electrode GE1 and a third gate electrode GE3 may be provided on each of the first channel patterns CH1. The first and third gate electrodes GE1 and GE3 may be spaced apart from each other, with the first source/drain pattern SD1 interposed therebetween.

The second gate electrode GE2 and a fourth gate electrode GE4 may be provided on each of the second channel patterns CH2. The second and fourth gate electrodes GE2 and GE4 may be spaced apart from each other, with the second source/drain pattern SD2 interposed therebetween.

The first and third gate electrodes GE1 and GE3 may include different metallic materials, and the second and fourth gate electrodes GE2 and GE4 may include different metallic materials. In other words, the first and third gate electrodes GE1 and GE3 may be formed of or include of different work function metals from each other, and the second and fourth gate electrodes GE2 and GE4 may be formed of or include of different work function metals from each other. In this case, the transistors including the third and fourth gate electrodes GE3 and GE4 may be configured to have a threshold voltage that is different from a threshold voltage of the transistors including the first and second gate electrodes GE1 and GE2. Accordingly, it may be possible to prevent a leakage current path from being formed between adjacent ones of the cells.

In the case where the first gate electrode GE1 is the gate electrode of the PMOS-FET and the second gate electrode GE2 is the gate electrode of the NMOS-FET, the third gate electrode GE3 may be the gate electrode of the NMOS-FET and the fourth gate electrode GE4 may be the gate electrode of the PMSOFET. In this case, a threshold voltage of the transistor including the fourth gate electrode GE4 may be greater than a threshold voltage of the transistor including the second gate electrode GE2.

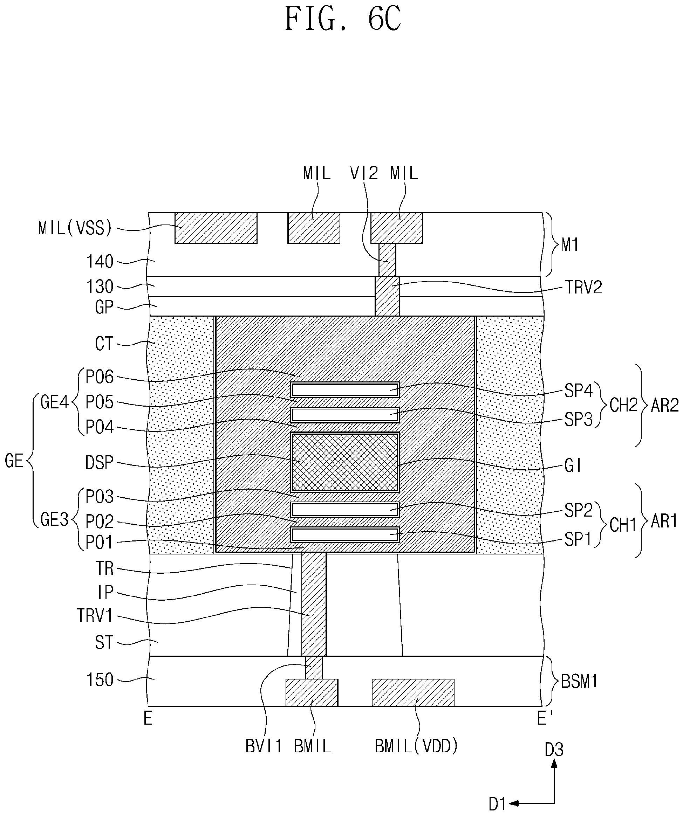

In FIG. 6C, the first and second source/drain patterns SD1 and SD2 may be electrically connected to each other using the gate electrode GE. For example, the gate electrode GE may include the third gate electrode GE3 and the fourth gate electrode GE4, and the third and fourth gate electrodes GE3 and GE4 may be in contact with each other.

In other words, the first and second source/drain patterns SD1 and SD2 may be electrically connected to each other through the bottom interconnection line BMIL, the first bottom via pattern BVI1, a penetration via pattern TRV, the third and fourth gate electrodes GE3 and GE4, the penetration via pattern TRV, the second upper via pattern VI2, and the upper interconnection line MIL.

FIGS. 7A to 25E are sectional views illustrating an example of a method of fabricating a semiconductor device according to some implementations. In detail, FIGS. 7A, 8A, 9A, 10A, 11A, 12A, 13A, 14A, 15A, 16A, 17A, 18A, 19A, 20A, 21A, 22A, 23A, 24A, and 25A are sectional views corresponding to the line A-A' of FIG. 3A. FIGS. 15B, 18B, 19B, 20B, and 23B are sectional views corresponding to the line B-B' of FIG. 3A. FIGS. 5B, 6B, 7B, 10B, 11B, 12, 13B, 14B, 15C, 18C, 19C, 20C, and 23C are sectional views corresponding to the line C-C' of FIG. 3A. FIGS. 7C, 8B, 9B, 15D, 18D, 19D, 20D, and 23D are sectional views corresponding to the line D-D' of FIG. 3A. FIGS. 16B, 17B, 18E, 19E, 20E, 21B, 22B, and 23E are sectional views corresponding to the line E-E' of FIG. 3A.

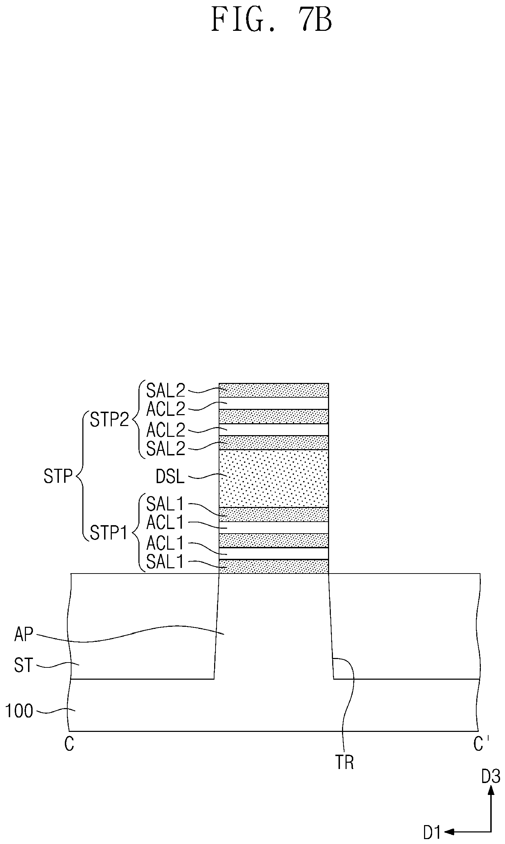

In FIGS. 7A and 7B, first sacrificial layers SAL1 and first active layers ACL1 may be alternatively stacked on a semiconductor substrate 100. The first sacrificial layers SAL1 and the first active layers ACL1 may be formed of or include at least one of silicon (Si), germanium (Ge), or silicon germanium (SiGe) and may be formed of different materials from each other. For example, the first sacrificial layers SAL1 may be formed of or include silicon germanium (SiGe), and the first active layers ACL1 may be formed of or include silicon (Si). A concentration of germanium (Ge) in each of the first sacrificial layers SAL1 may range from 10 at% to 30 at%.

A division layer DSL may be formed on the uppermost one of the first sacrificial layers SAL1. In some implementations, a thickness of the division layer DSL may be larger than a thickness of each of the first active layer ACL1 and the first sacrificial layer SAL1. The division layer DSL may be formed of or include silicon (Si) or silicon germanium (SiGe). In the case where the division layer DSL includes silicon germanium (SiGe), a germanium concentration of the division layer DSL may be higher than a germanium concentration of the first sacrificial layer SAL1. For example, the germanium concentration of the division layer DSL may range from 40 at% to 90 at%.

Second sacrificial layers SAL2 and second active layers ACL2 may be alternatively stacked on the division layer DSL. Each of the second sacrificial layers SAL2 may be formed of or include the same material as the first sacrificial layer SAL1, and each of the second active layers ACL2 may be formed of or include the same material as the first active layer ACL1. The division layer DSL may be interposed between the first sacrificial layer SAL1 and the second sacrificial layer SAL2.

The first and second sacrificial layers SAL1 and SAL2, the first and second active layers ACL1 and ACL2, and the division layer DSL may be patterned to form a stacking pattern STP. The formation of the stacking pattern STP may include forming a hard mask pattern on the uppermost one of the second active layers ACL2 and etching the layers SAL1, SAL2, ACL1, ACL2, and DSL on the semiconductor substrate 100 using the hard mask pattern as an etch mask. During the formation of the stacking pattern STP, an upper portion of the semiconductor substrate 100 may be etched to form the trench TR defining an active pattern AP. The stacking pattern STP may be a bar-shaped pattern extended in the second direction D2.

The stacking pattern STP may include a lower stacking pattern STP1 on the active pattern AP, an upper stacking pattern STP2 on the lower stacking pattern STP1, and the division layer DSL between the lower and upper stacking patterns STP1 and STP2. The lower stacking pattern STP1 may include the first sacrificial layers SAL1 and the first active layers ACL1, which are alternately stacked. The upper stacking pattern STP2 may include the second sacrificial layers SAL2 and the second active layers ACL2, which are alternately stacked.

The device isolation layer ST may be formed on the semiconductor substrate 100 to fill the trench TR. For example, an insulating layer may be formed on the front surface of the semiconductor substrate 100 to cover the active pattern AP and the stacking pattern STP. The device isolation layer ST may be formed by recessing the insulating layer to expose the stacking pattern STP.

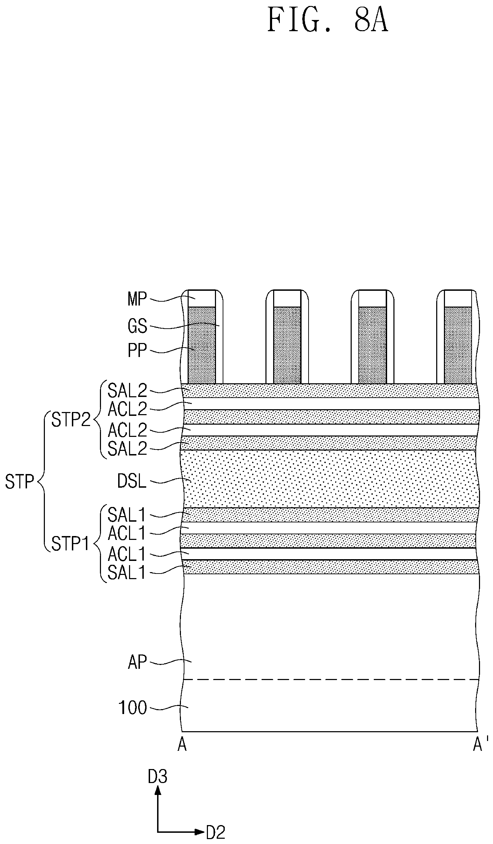

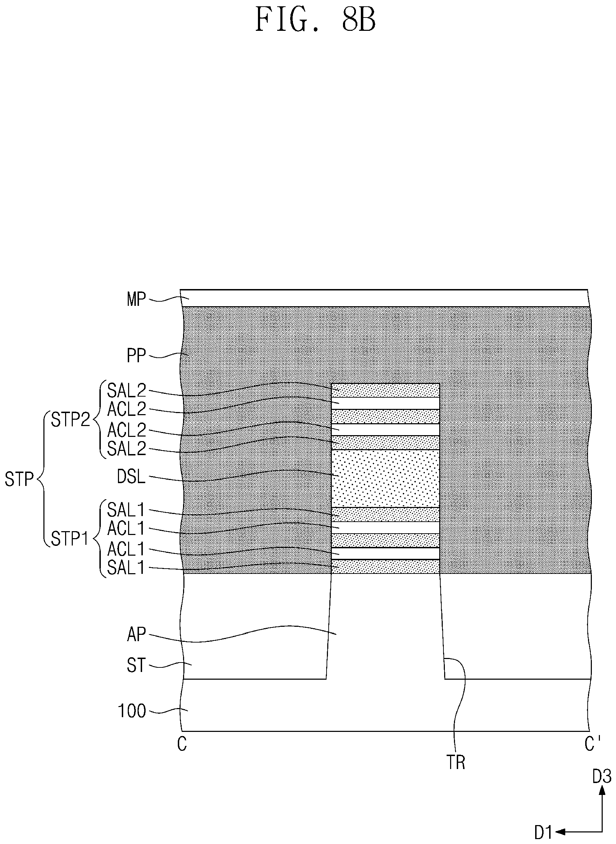

In FIGS. 8A and 8B, a sacrificial pattern PP may be formed to cross the stacking pattern STP. The sacrificial pattern PP may be formed to have a line shape extending in the first direction D1. For example, the formation of the sacrificial pattern PP may include forming a sacrificial layer on the front surface of the semiconductor substrate 100, forming a hard mask pattern MP on the sacrificial layer, and patterning the sacrificial layer using the hard mask pattern MP as an etch mask. The sacrificial layer may be formed of or include amorphous silicon and/or polysilicon.

A pair of the gate spacers GS may be formed on opposite side surfaces of the sacrificial pattern PP, respectively. For example, a spacer layer may be conformally formed on the front surface of the semiconductor substrate 100. The spacer layer may cover the sacrificial pattern PP and the hard mask pattern MP. For example, the spacer layer may be formed of or include at least one of SiCN, SiCON, or SiN. The gate spacers GS may be formed by anisotropically etching the spacer layer.

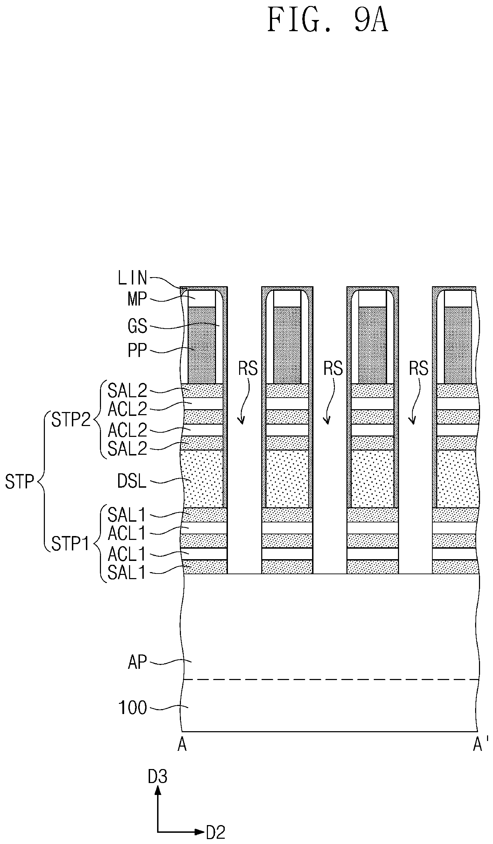

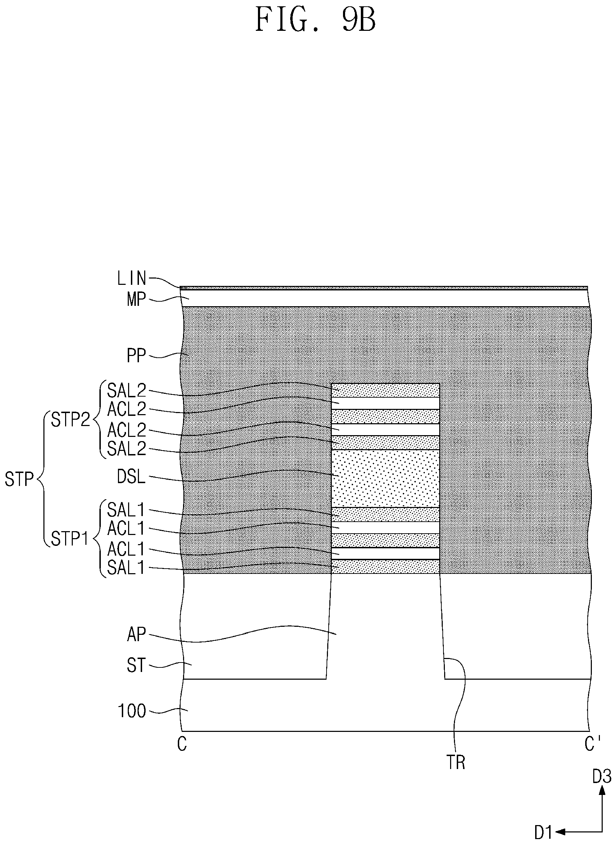

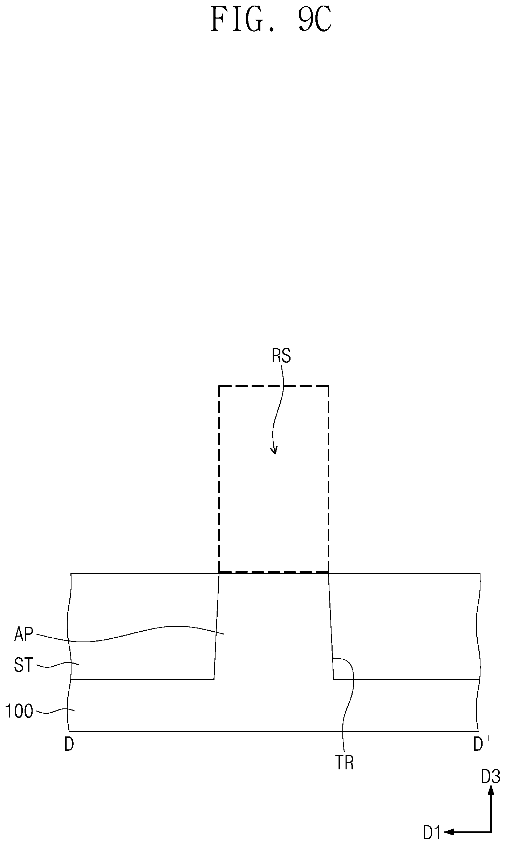

In FIGS. 9A to 9C, an etching process may be performed on the stacking pattern STP using the gate spacers GS and the hard mask pattern MP as an etch mask. Recesses RS may be formed at both sides of the sacrificial pattern PP by the etching process.

Liner layers LIN may be uniformly formed on opposite side surfaces of the upper stacking pattern STP2, opposite side surfaces of the gate spacer GS, and a top surface of the hard mask pattern MP. The liner layers LIN may prevent the upper stacking pattern STP2 from being exposed to the recesses RS. The liner layers LIN may be formed to expose the lower stacking pattern STP1. In some implementations, the liner layers LIN may include silicon nitride.

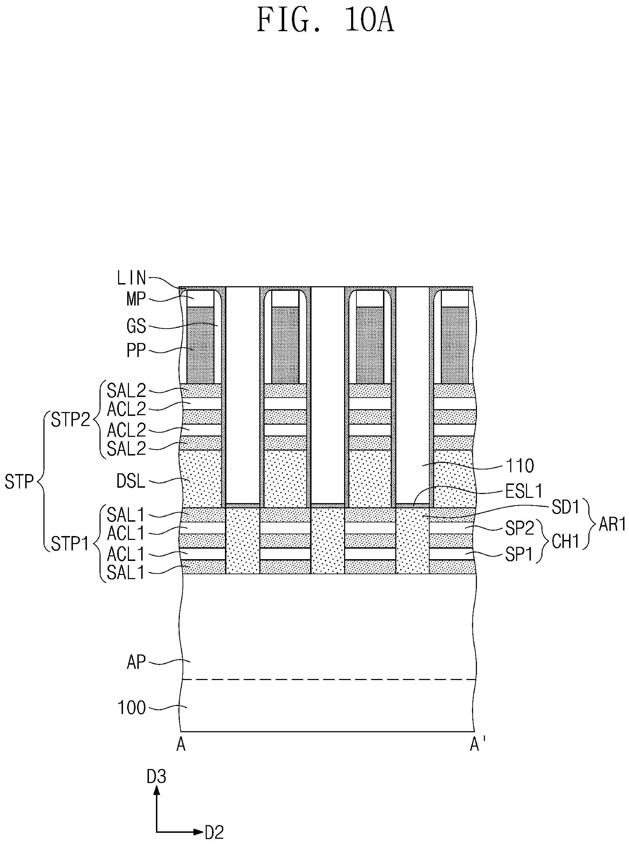

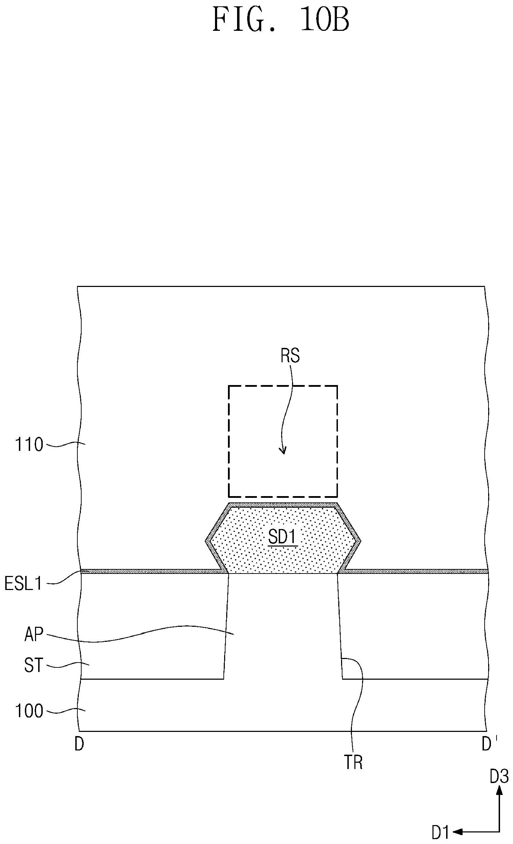

In FIGS. 10A and 10B, the first source/drain patterns SD1 may be formed in the recesses RS, respectively. For example, the first source/drain pattern SD1 may be formed by a first SEG process, in which the exposed side surface of the lower stacking pattern STP1 is used as a seed layer. The first source/drain pattern SD1 may be grown using the first active layers ACL1 and the active pattern AP, which are exposed by the recess RS, as a seed layer. In some implementations, the first SEG process may include a chemical vapor deposition (CVD) process or a molecular beam epitaxy (MBE) process.

During the first SEG process, impurities may be injected into the first source/drain pattern SD1 in an in-situ manner. In some implementations, impurities may be injected into the first source/drain pattern SD1, after the formation of the first source/drain pattern SD1. The first source/drain pattern SD1 may be doped to have a first conductivity type (e.g., p type).

The first active layers ACL1, which are interposed between a pair of the first source/drain patterns SD1, may constitute the first channel pattern CH1. In other words, the first and second semiconductor patterns SP1 and SP2 of the first channel pattern CH1 may be formed from the first active layers ACL1. The first channel pattern CH1 and the first source/drain patterns SD1 may constitute the first active region AR1, which is the bottom tier of the three-dimensional device.

A side surface of the upper stacking pattern STP2 may be covered with the liner layer LIN. That is, due to the liner layer LIN, the second active layers ACL2 of the upper stacking pattern STP2 may not be exposed to the outside during the first SEG process. Accordingly, during the first SEG process, an additional semiconductor layer may not be grown on the upper stacking pattern STP2.

The first etch stop layer ESL1 may be formed to cover the first source/drain patterns SD1, and the first interlayer insulating layer 110 may be formed on the first etch stop layer ESL1. The top surface of the first interlayer insulating layer 110 may be coplanar with a top surface of the liner layer LIN. The first interlayer insulating layer 110 may fill the recesses RS, after the formation of the first source/drain pattern SD1. In some implementations, the first interlayer insulating layer 110 may include a silicon oxide layer.

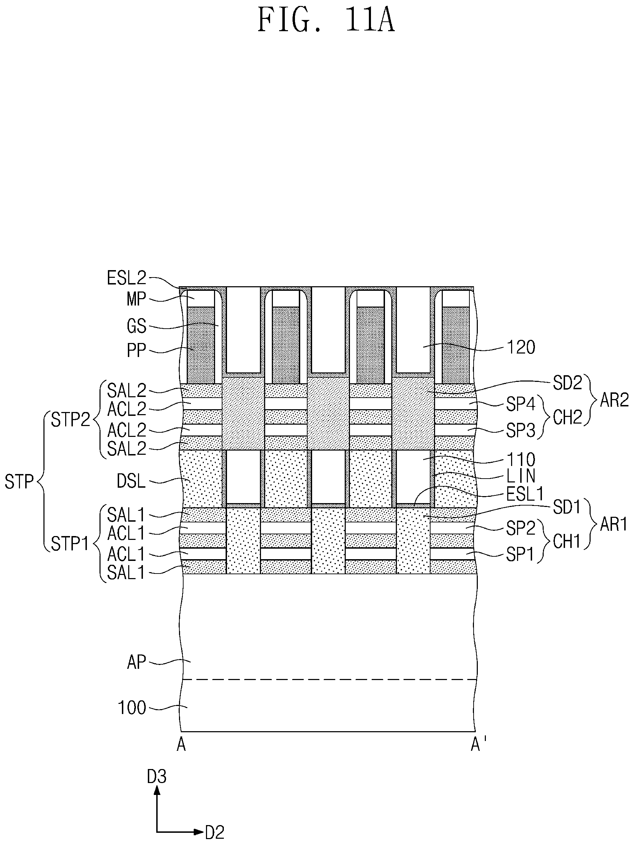

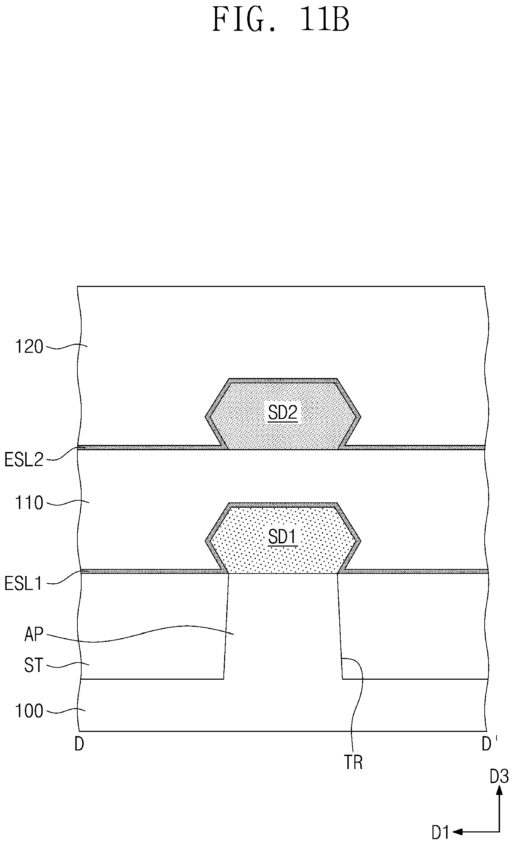

In FIGS. 11A and 11B, the top surface of the first interlayer insulating layer 110 may be recessed to a level of a bottom surface of the lowermost one of the second active layers ACL2. An exposed portion of the liner layer LIN may be removed, as a result of the recessing step. A remaining portion of the liner layer LIN, which is covered with the first interlayer insulating layer 110, may cover a side surface of the division layer DSL. Since the liner layer LIN is removed, the second active layers ACL2 may be exposed to the outside, after the recessing step.

The second source/drain patterns SD2 may be formed on opposite side surfaces of the upper stacking pattern STP2, respectively. For example, the second source/drain pattern SD2 may be formed by a second SEG process, in which the side surface of the upper stacking pattern STP2 is used as a seed layer. The second source/drain pattern SD2 may be grown using the second active layers ACL2, which are exposed by the recess RS, as a seed layer. The second source/drain patterns SD2 may be doped to have a second conductivity type (e.g., an n type) different from the first conductivity type.

The second active layers ACL2, which are interposed between a pair of the second source/drain patterns SD2, may constitute the second channel pattern CH2. That is, the third and fourth semiconductor patterns SP3 and SP4 of the second channel pattern CH2 may be formed from the second active layers ACL2. The second channel pattern CH2 and the second source/drain patterns SD2 may constitute the second active region AR2, which is the top tier of the three-dimensional device.

The liner layer LIN may be removed by an etching process. The second etch stop layer ESL2 may be formed to cover the second source/drain pattern SD2, the gate spacer GS, and the hard mask pattern MP. The second interlayer insulating layer 120 may be formed on the second etch stop layer ESL2. The top surface of the second interlayer insulating layer 120 may be coplanar with the top surface of the liner layer LIN on the hard mask pattern MP. In some implementations, the second interlayer insulating layer 120 may include a silicon oxide layer.

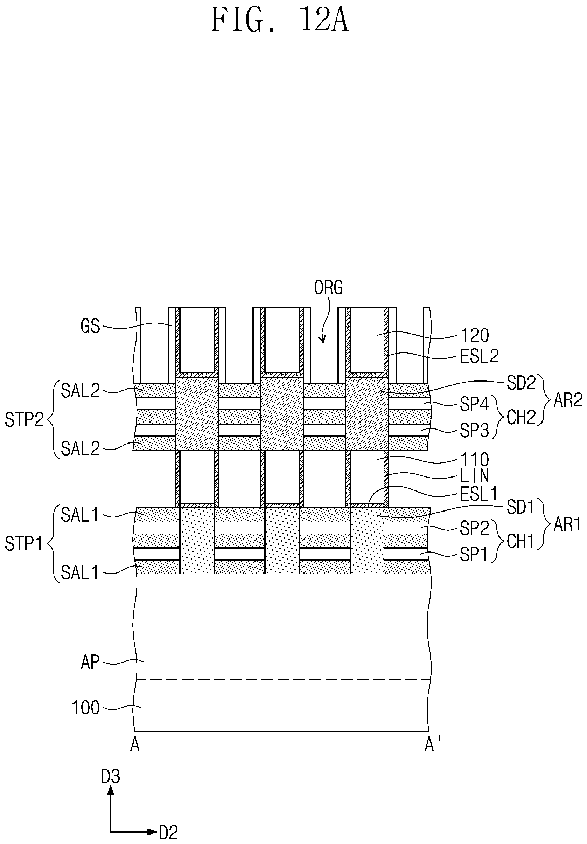

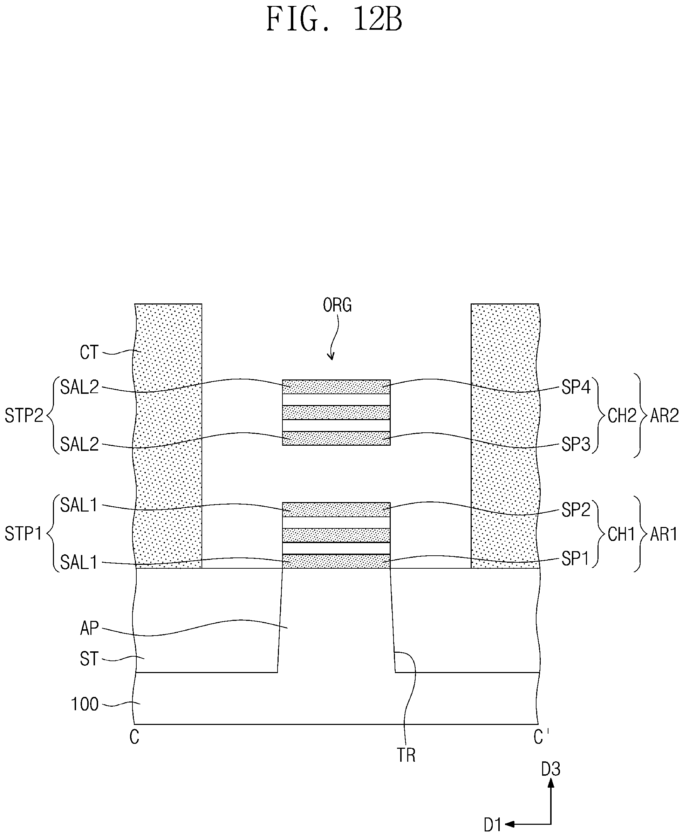

In FIGS. 12A and 12B, the second interlayer insulating layer 120 and the second etch stop layer ESL2 may be planarized to expose a top surface of the sacrificial pattern PP. The planarization of the second interlayer insulating layer 120 and the second etch stop layer ESL2 may be performed using an etch-back process or a chemical mechanical polishing (CMP) process. The hard mask pattern MP may be fully removed during the planarization process. As a result, the top surface of the second interlayer insulating layer 120 may be coplanar with the top surface of the sacrificial pattern PP and the top surfaces of the gate spacers GS.

In FIG. 12B, the cutting pattern CT may be formed to penetrate the sacrificial pattern PP. The cutting patterns CT may be formed on cell borders of the logic cell. The cutting patterns CT may be formed of or include at least one of silicon oxide and/or silicon nitride.

The exposed sacrificial pattern PP may be selectively removed. As a result of the removal of the sacrificial pattern PP, an outer region ORG may be formed to expose the first and seconds channel patterns CH1 and CH2 (e.g., see FIG. 12B). The removal of the sacrificial pattern PP may include a wet etching process that is performed using etching solution capable of selectively etching polysilicon.

In some implementations, the division layer DSL, which is exposed through the outer region ORG, may be removed by a wet etching process that is performed using etching solution capable of selectively etching polysilicon.

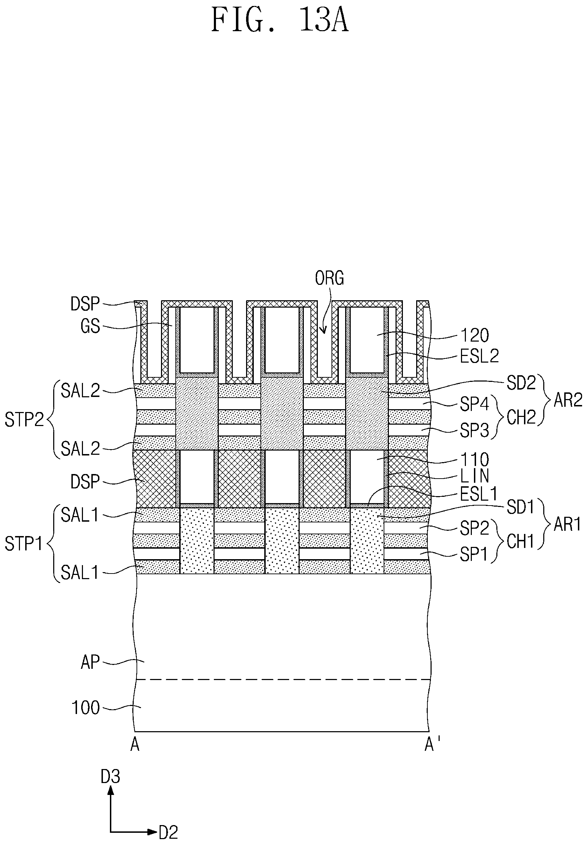

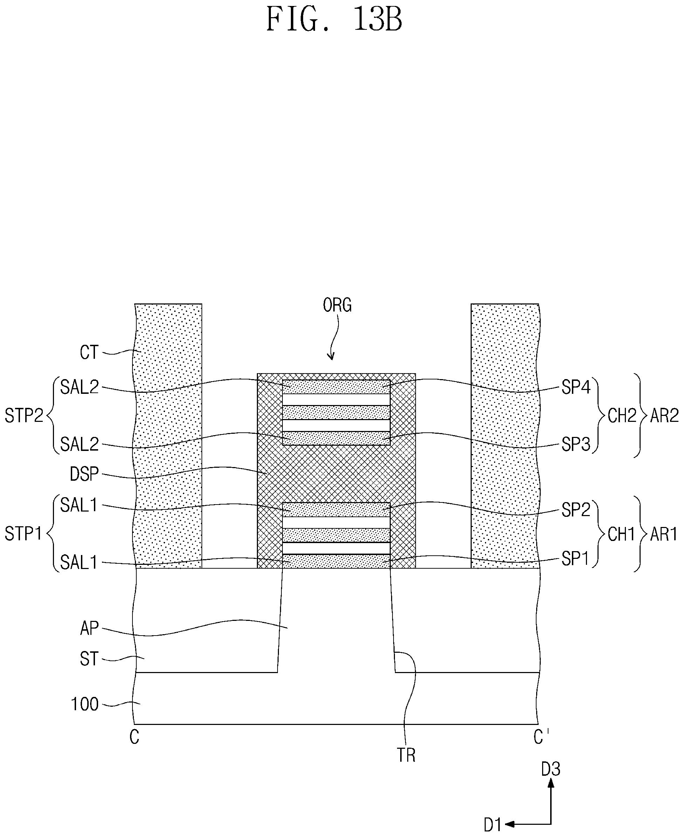

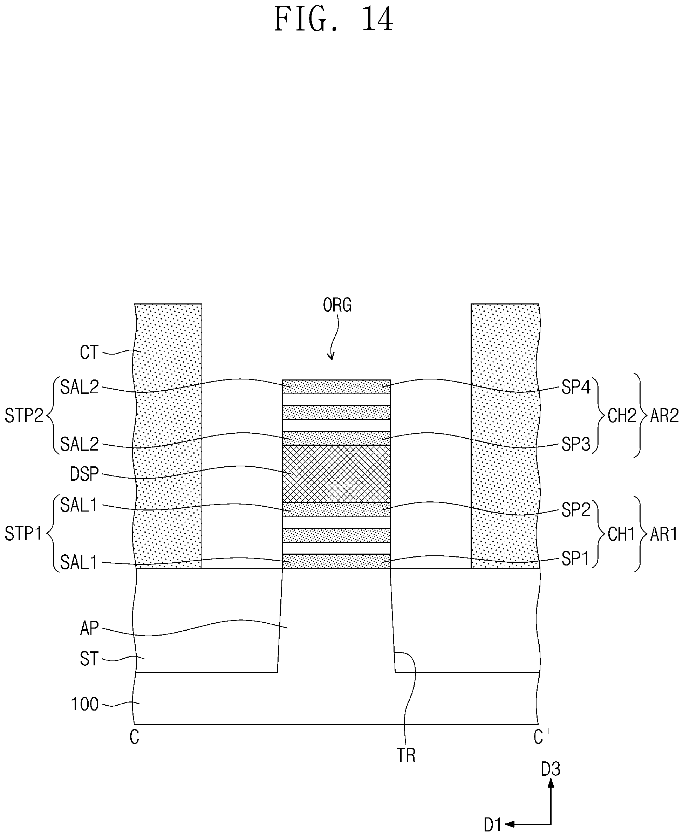

In FIGS. 13A, 13B, and 14, the dummy pattern DSP may be formed to cover the lower and upper stacking patterns STP1 and STP2 exposed through the outer region ORG. The dummy pattern DSP may cover the gate spacer GS, the second etch stop layer ESL2, and the second interlayer insulating layer 120 (e.g., see FIG. 13A). The dummy pattern DSP may include a silicon-based insulating material, and in the present embodiment, the dummy pattern DSP may include a silicon nitride layer.

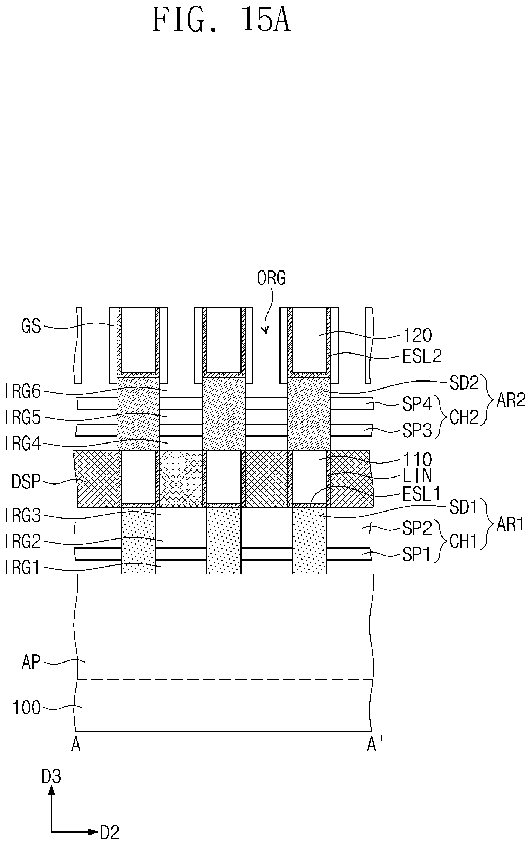

A dry etching process may be performed to locally leave the dummy pattern DSP between the lower and upper stacking patterns STP1 and STP2. The dummy pattern DSP may be interposed between the lower and upper stacking patterns STP1 and STP2, and between the uppermost one of the first sacrificial layers SAL1 of the lower stacking pattern STP1 and the lowermost one of the second sacrificial layers SAL2 n FIGS. 15A and 15B, the first and second sacrificial layers SAL1 and SAL2 exposed through the outer region ORG may be selectively removed to form first to sixth inner regions IRG1 to IRG6, respectively (e.g., see FIG. 15B). For example, an etching process of selectively etching the first and second sacrificial layers SAL1 and SAL2 may be performed to leave the first to fourth semiconductor patterns SP1 to SP4 and the dummy pattern DSP and to remove only the first and second sacrificial layers SAL1 and SAL2. The etching process may be performed using an etch recipe that is chosen to have a high etch rate to a silicon germanium pattern having a relatively high germanium concentration. For example, the etching process may be chosen to have a high etch rate to a silicon germanium layer whose germanium concentration is higher than 10 at%.

Since the first and second sacrificial layers SAL1 and SAL2 are selectively removed, the first and second semiconductor patterns SP1 and SP2 may be left on the first active region AR1, and the third and fourth semiconductor patterns SP3 and SP4 may be left on the second active region AR2. The dummy pattern DSP may be left between the second semiconductor pattern SP2 and the third semiconductor pattern SP3.

An empty space between the active pattern AP and the first semiconductor pattern SP1 may be defined as the first inner region IRG1, an empty space between the first semiconductor pattern SP1 and the second semiconductor pattern SP2 may be defined as the second inner region IRG2, and an empty space between the second semiconductor pattern SP2 and the dummy pattern DSP may be defined as the third inner region IRG3. An empty space between the dummy pattern DSP and the third semiconductor pattern SP3 may be defined as the fourth inner region IRG4, an empty space between the third semiconductor pattern SP3 and the fourth semiconductor pattern SP4 may be defined as the fifth inner region IRG5, and an empty space on the fourth semiconductor pattern SP4 may be defined as the sixth inner region IRG6. The sixth inner region IRG6 may be defined as an empty region that is extended to the outer region ORG.

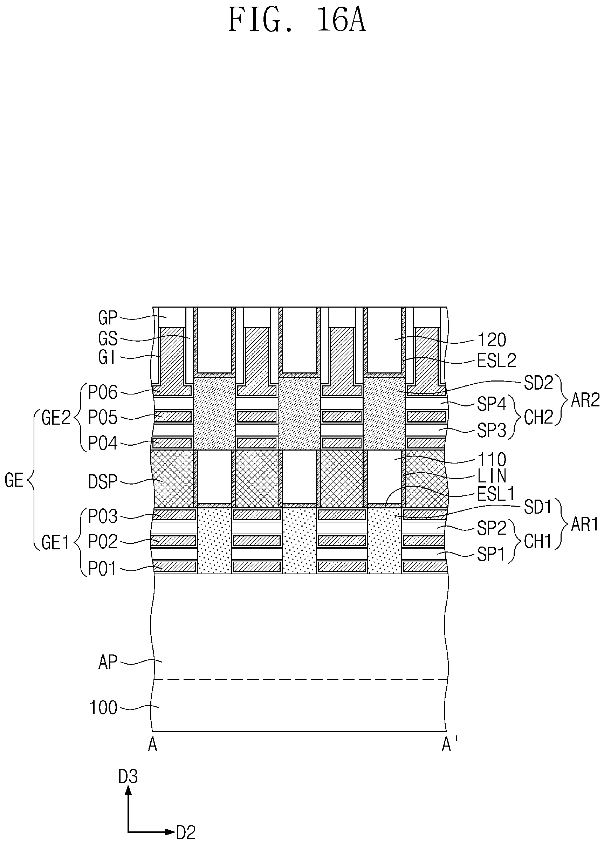

In FIGS. 16A and 16B, the gate insulating layer GI may be conformally formed on the first to fourth semiconductor patterns SP1 to SP4 exposed. The gate electrode GE may be formed on the gate insulating layer GI. The formation of the gate electrode GE may include forming the first to fifth inner electrodes PO1-PO5 in the first to fifth inner regions IRG1-IRG5, respectively, and forming the outer electrode PO6 in the outer region ORG (or the sixth inner region IRG6).

The gate electrode GE may be vertically recessed to have a reduced height. The gate capping pattern GP may be formed on the recessed gate electrode GE. A planarization process may be performed on the gate capping pattern GP such that the top surface of the gate capping pattern GP is coplanar with the top surface of the second interlayer insulating layer 120 and the top surface of the second etch stop layer ESL2.

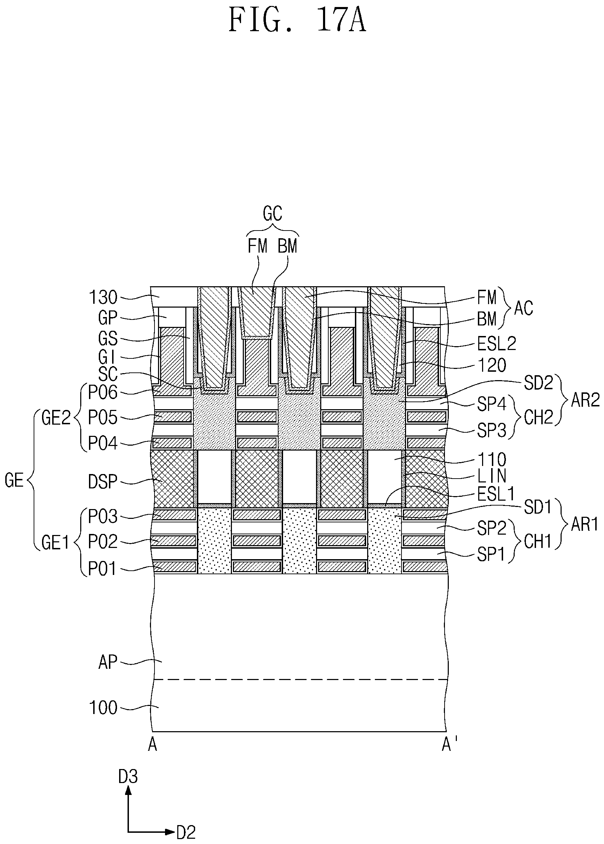

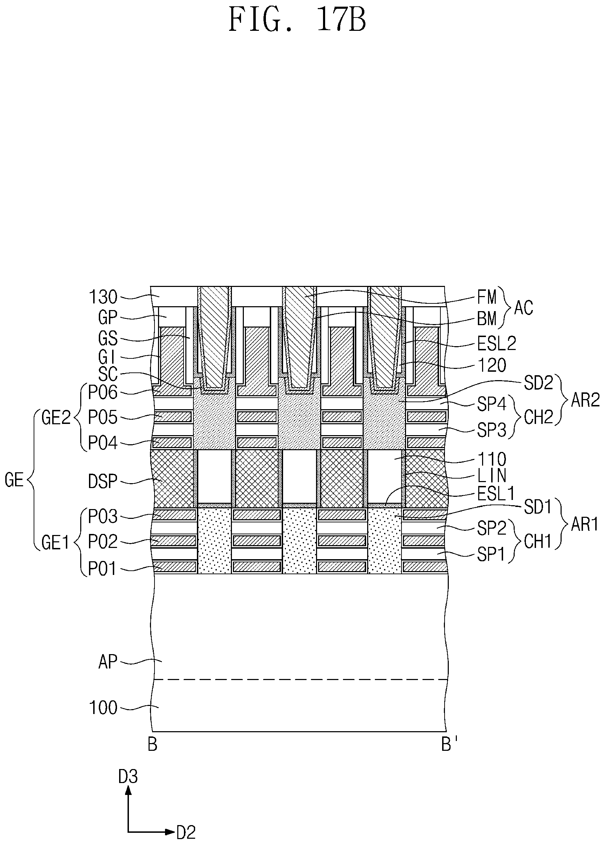

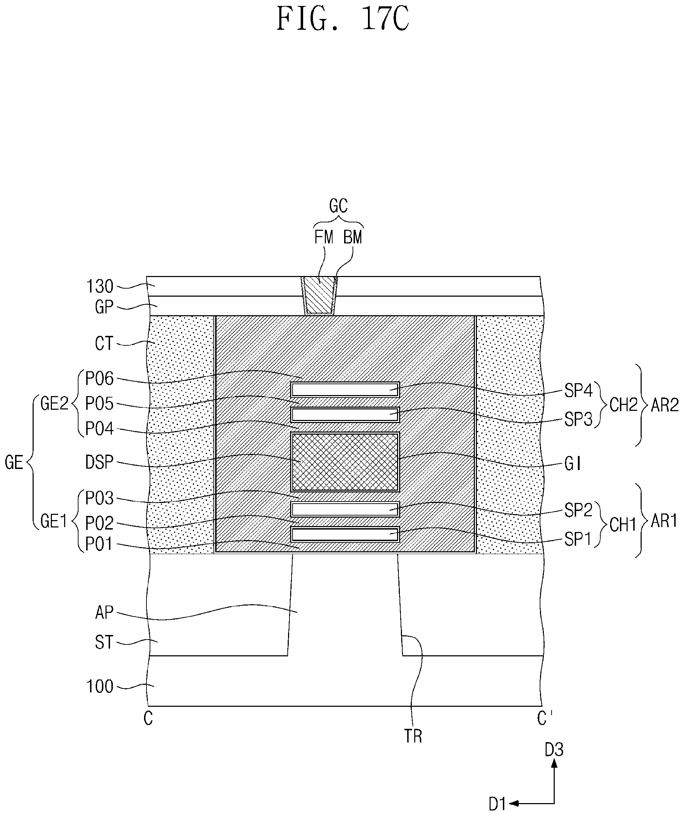

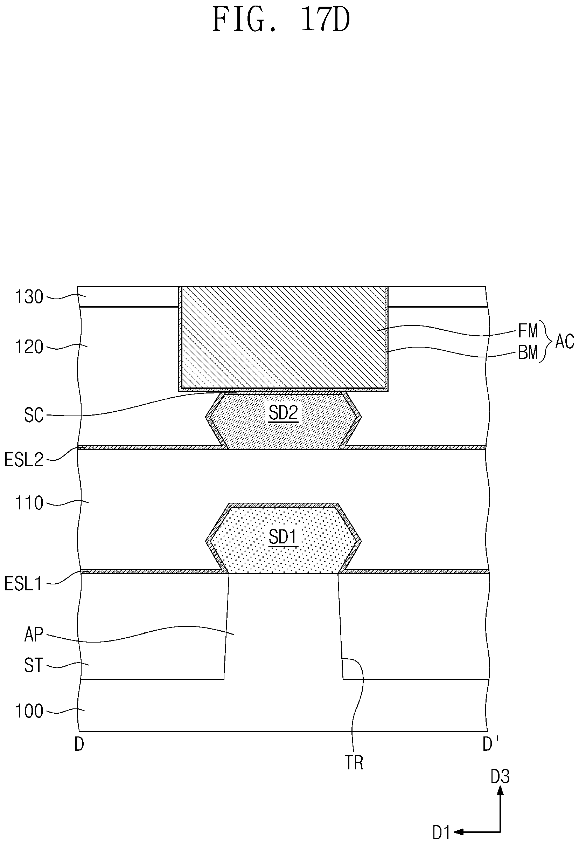

In FIGS. 17A to 17D, the third interlayer insulating layer 130 may be formed on the second interlayer insulating layer 120 and the gate capping pattern GP. In some implementations, the third interlayer insulating layer 130 may include a silicon oxide layer.

Contact holes may be formed to penetrate the third interlayer insulating layer 130, the second etch stop layer ESL2, and the second interlayer insulating layer 120. The upper active contact AC may be formed on the second source/drain pattern SD2 exposed by the contact holes. The upper active contact AC may be formed in a self-aligned manner using the gate capping pattern GP and the gate spacer GS.

A gate contact hole may be formed to penetrate the third interlayer insulating layer 130 and the gate capping pattern GP. The gate contact GC may be formed on the outer electrode PO6 exposed by the gate contact hole.

For example, the formation of the upper active contact AC and the gate contact GC may include forming the barrier pattern BM and forming the conductive pattern FM on the barrier pattern BM. The metal-semiconductor compound layer SC may be further formed between the upper active contact AC and each of the second source/drain patterns SD2. The upper active contact AC may be electrically connected to the second source/drain pattern SD2, and the gate contact GC may be connected to the second gate electrode GE2.

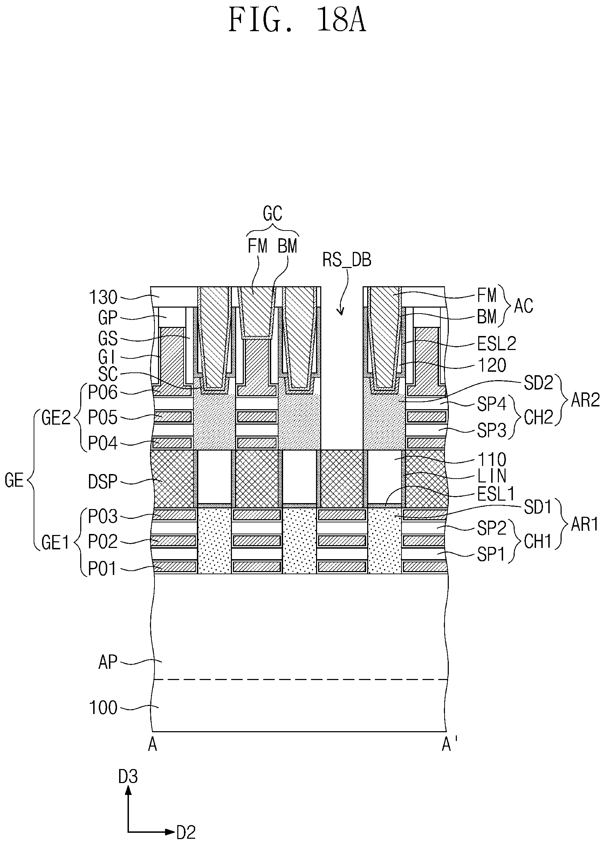

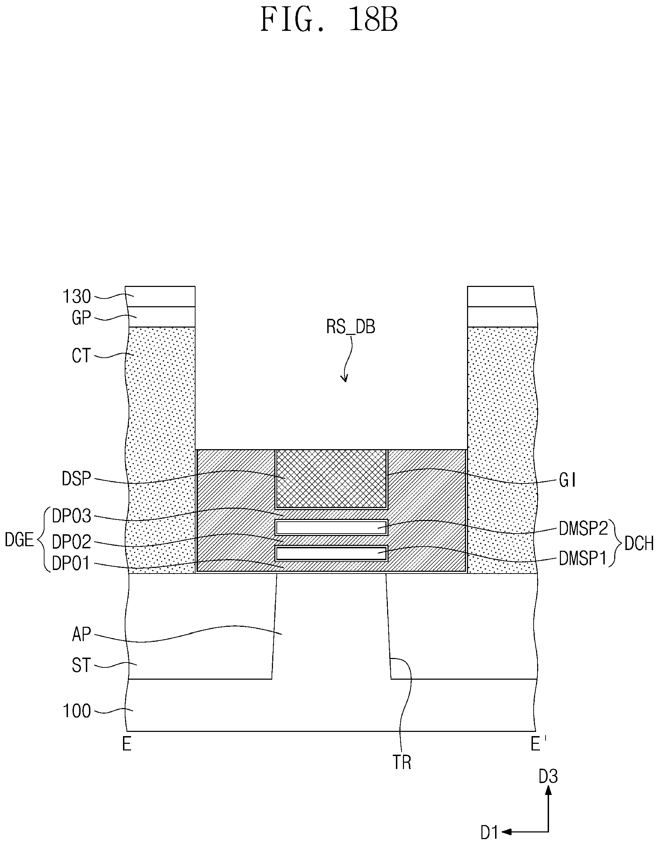

In FIGS. 18A and 18B, a hard mask pattern may be formed on the third interlayer insulating layer 130, the upper active contact AC, and the gate contact GC, and an etching process using the hard mask pattern may be performed. The etching process may be an anisotropic dry etching process. A division recess region RS_DB may be formed by the etching process. In some implementations, the division recess region RS_DB may be formed to expose a top surface of the dummy pattern DSP and side surfaces of a pair of the second source/drain patterns SD2.

For example, the division recess region RS_DB may be formed to penetrate the third interlayer insulating layer 130 and the gate capping pattern GP and to expose the top surface of the dummy pattern DSP. A portion of a side surface of the cutting pattern CT may be exposed through the division recess region RS_DB (e.g., see FIG. 18B). The exposed top surface of the dummy pattern DSP may be coplanar with a top surface of the dummy gate electrode DGE and a top surface of the gate insulating layer GI.

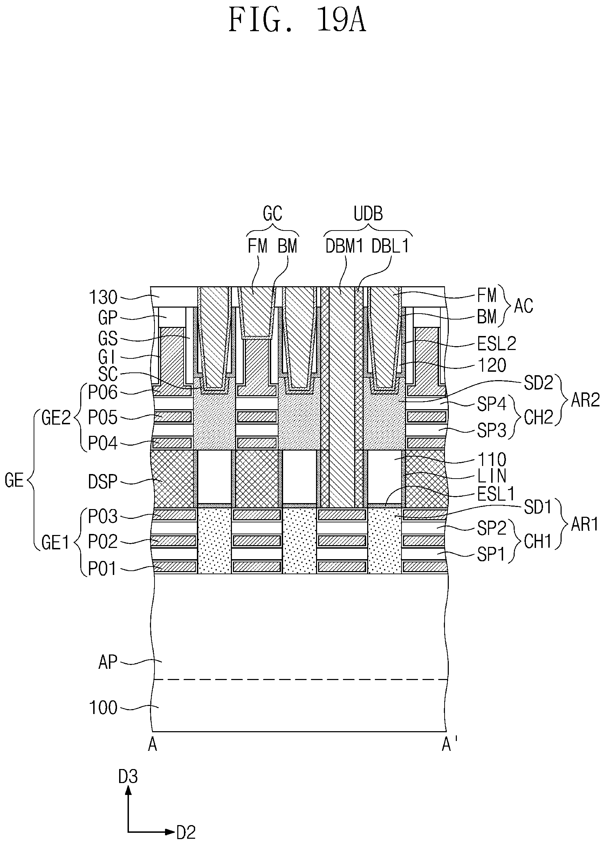

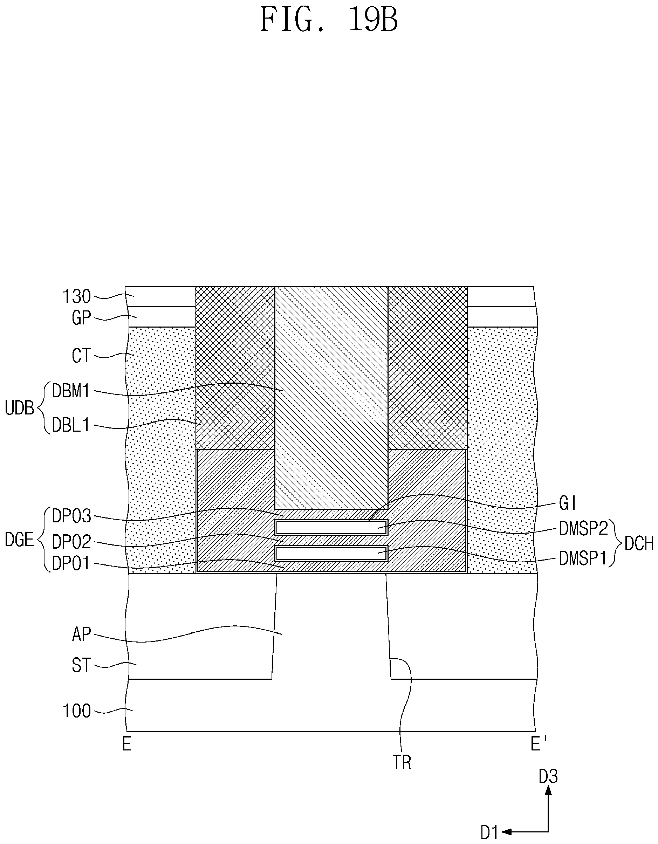

In FIGS. 19A and 19B, the upper division structure UDB may be formed in the division recess region RS_DB. The formation of the upper division structure UDB may include forming the first division liner pattern DBL1 in the division recess region RS_DB, performing an etching process to remove a portion of the first division liner pattern DBL1 and the dummy pattern DSP, and forming the first connection metal pattern DBM1.

A bottom surface of the first connection metal pattern DBM1 may be located at a level lower than a bottom surface of the first division liner pattern DBL1 in the third direction D3. That is, the first connection metal pattern DBM1 may be formed to include a portion that is extended into the dummy gate electrode DGE.

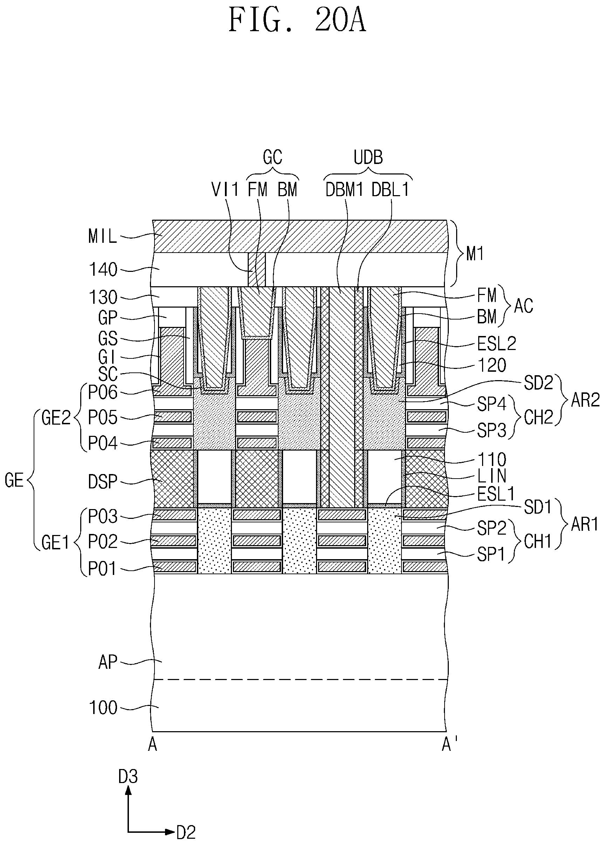

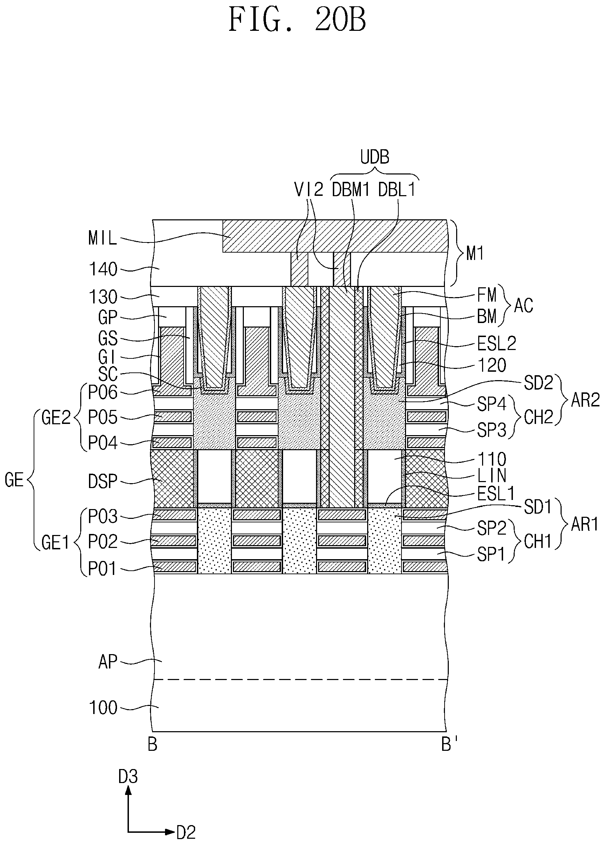

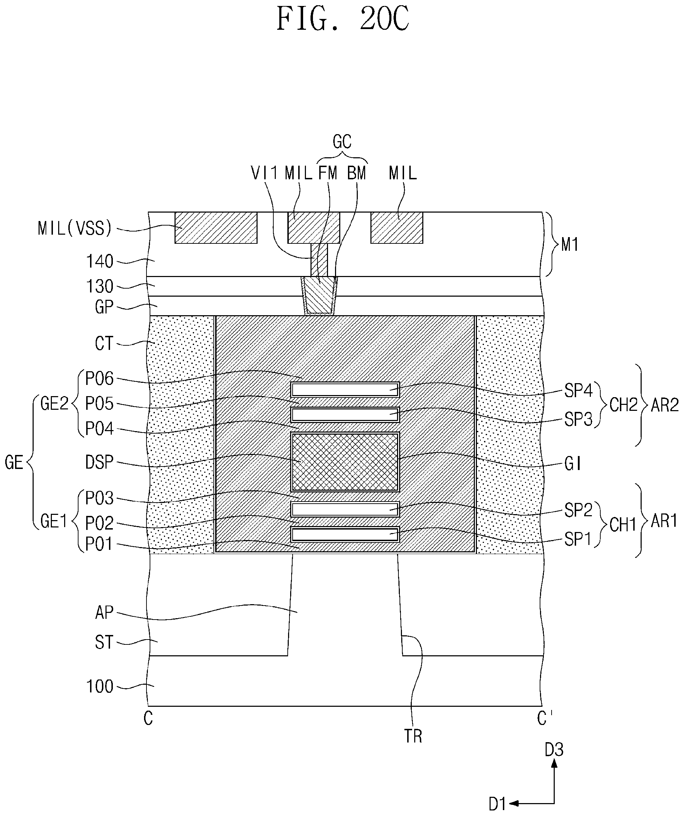

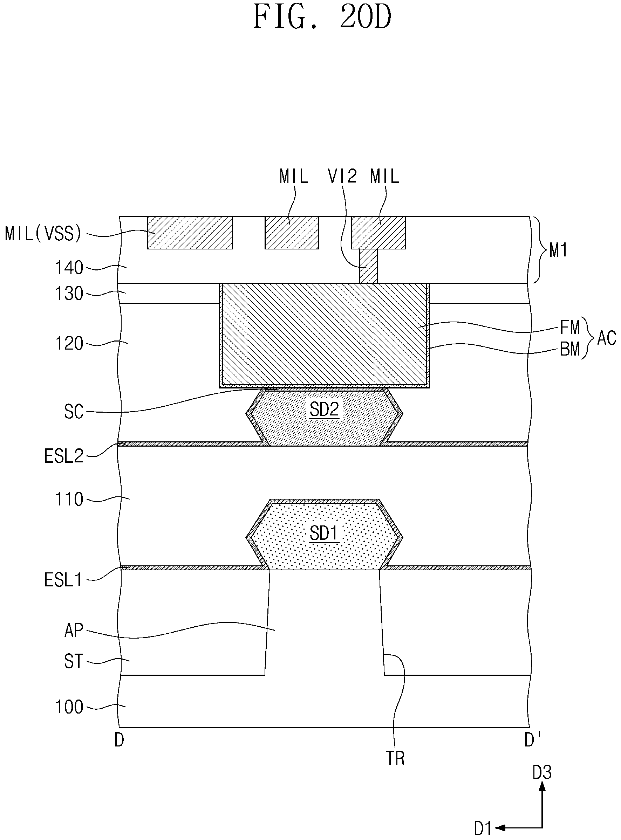

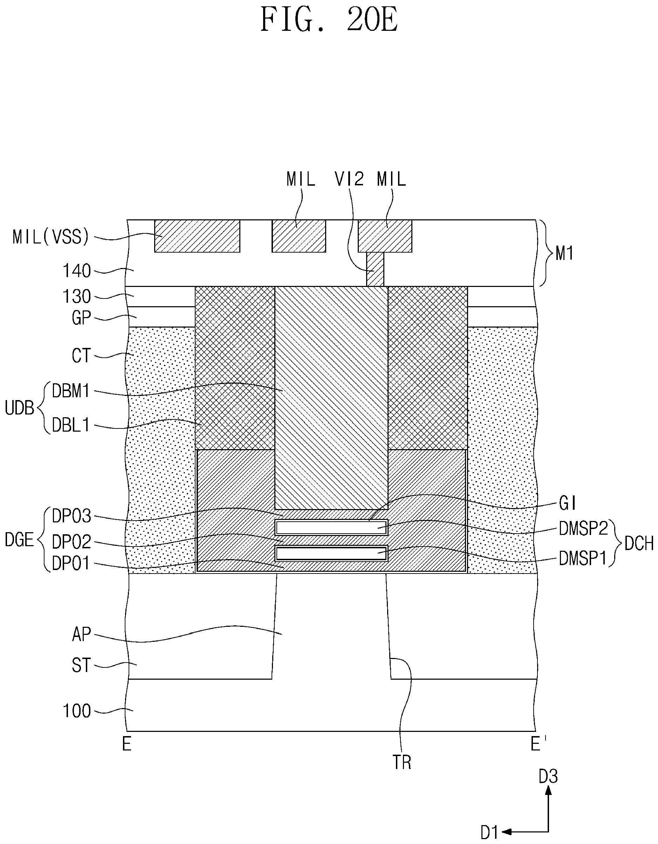

In FIGS. 20A to 20E, the fourth interlayer insulating layer 140 may be formed on the third interlayer insulating layer 130, the upper active contacts AC, the gate contact GC, and the upper division structure UDB. The upper via patterns VI1 and VI2 and the upper interconnection lines MIL may be formed in the fourth interlayer insulating layer 140. The upper via patterns VI1 and VI2 and the upper interconnection lines MIL may be defined as the first metal layer M1.

For example, the upper division structure UDB may be electrically connected to the second source/drain pattern SD2 through the second upper via patterns VI2, the upper interconnection lines MIL, and the upper active contact AC. The second gate electrode GE2 may be electrically connected to the upper interconnection line MIL through the first upper via pattern VI1.

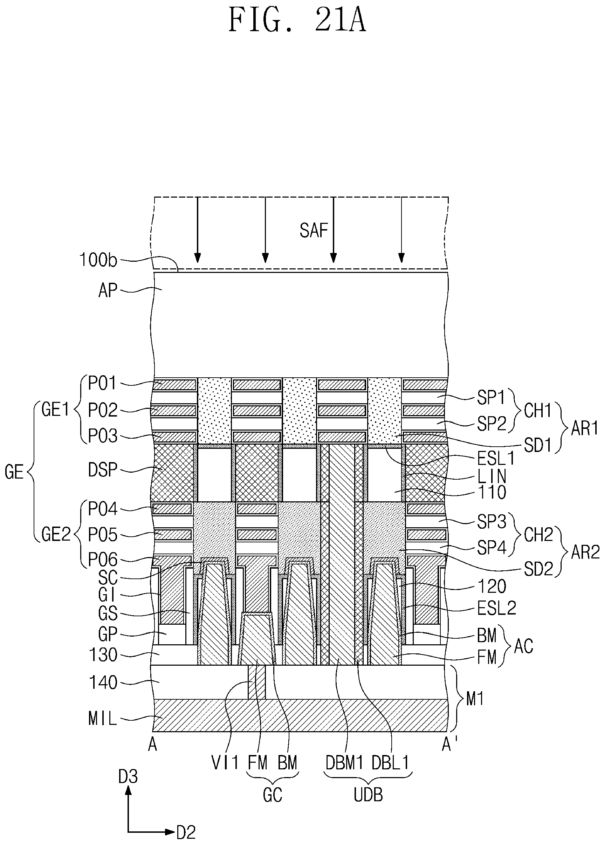

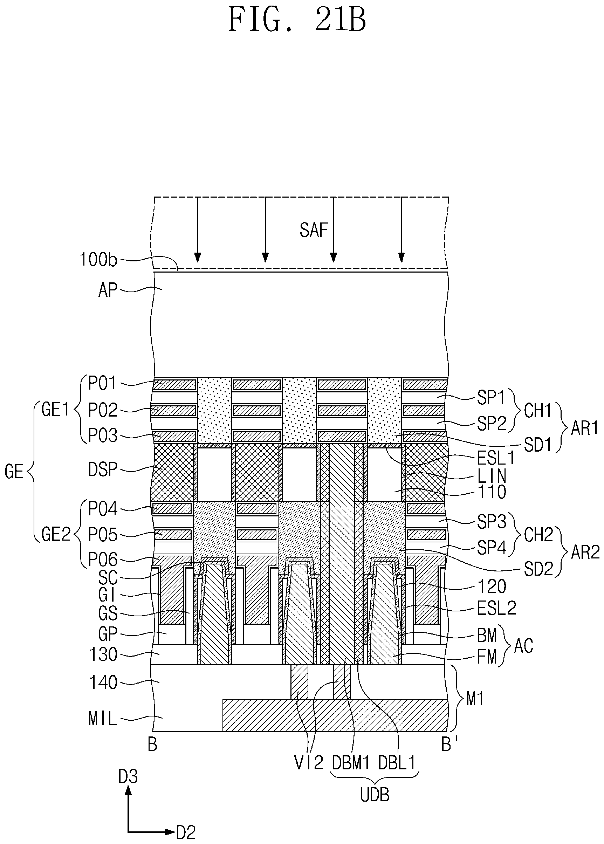

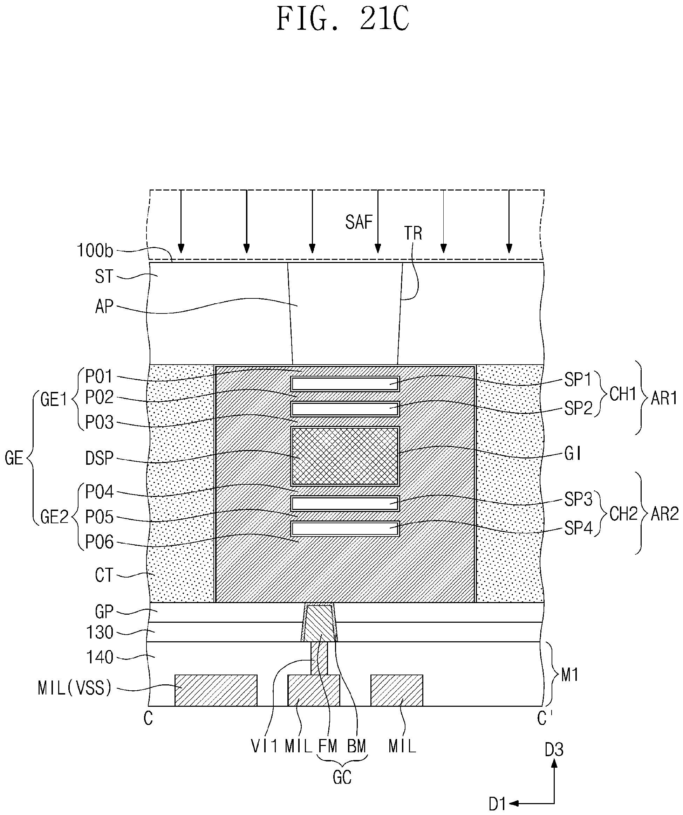

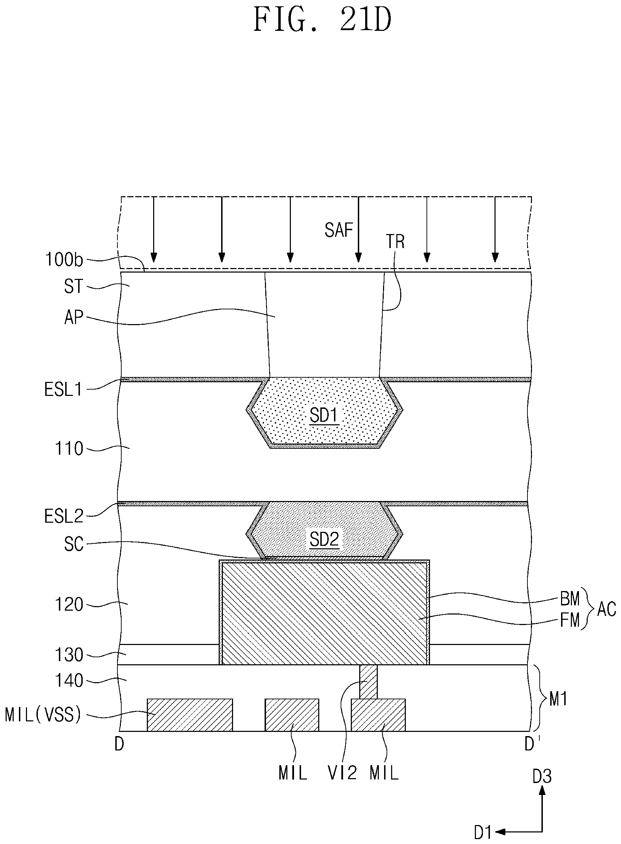

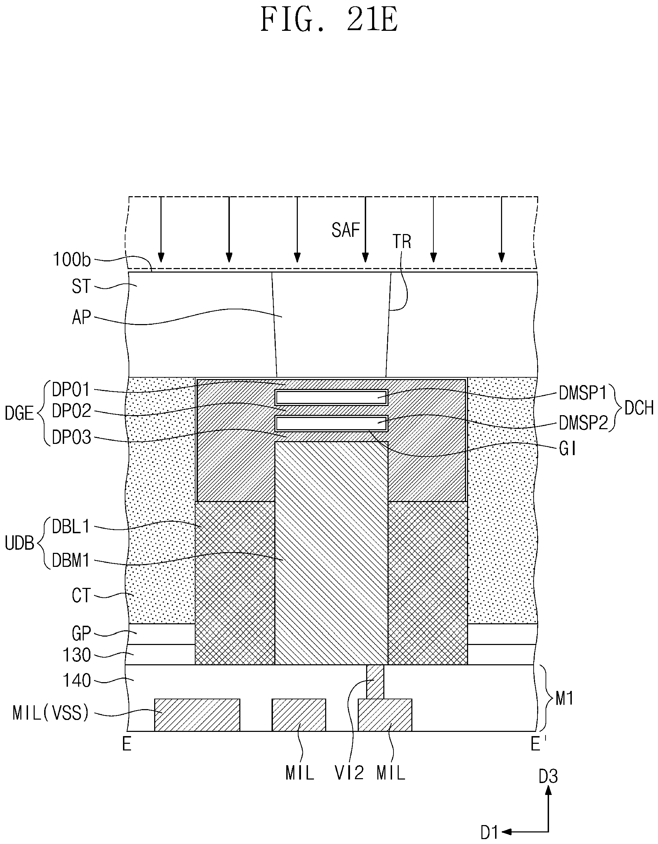

The semiconductor substrate 100 of FIGS. 7A to 20E may be inverted, after a back-end-of-line (BEOL) process. Given that the semiconductor substrate 100 is inverted, the terminologies 'top surface' and 'upper portion' in the following description of FIGS. 21A to 25E should be understood as referring to the 'bottom surface' and 'lower portion', respectively, in the final structure of the three-dimensional semiconductor device described with reference to FIGS. 4A to 4E, and the terminologies 'bottom surface' and 'lower portion' should be understood as referring to the 'top surface' and 'upper portion', respectively, in the final structure of the three-dimensional semiconductor device described with reference to FIGS. 4A to 4E.

In FIGS. 21A to 21E, if a BEOL process is finished, the semiconductor substrate 100 may be inverted such that a bottom surface of the semiconductor substrate 100 is exposed to the outside. A portion of the semiconductor substrate 100 exposed may be removed.

In some implementations, the partial removal of the semiconductor substrate 100 may include performing a planarization process SAF on a bottom surface 100b of the semiconductor substrate 100 to reduce a thickness of the semiconductor substrate 100 and performing a cleaning process of selectively removing silicon (Si) atoms from the semiconductor substrate 100. That is, the device isolation layer ST may be exposed, after the partial removal of the semiconductor substrate 100. In this case, the top surface of the device isolation layer ST may be coplanar with a top surface of the active pattern AP.

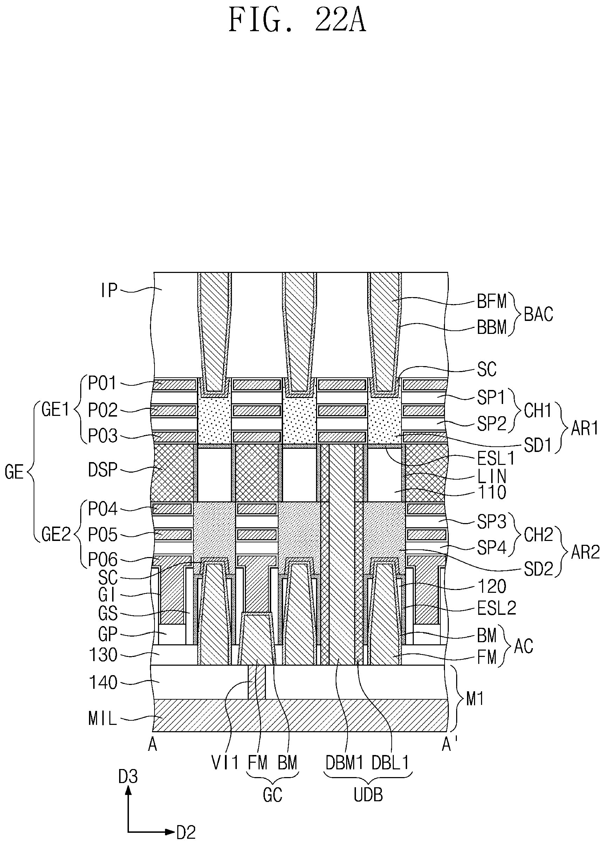

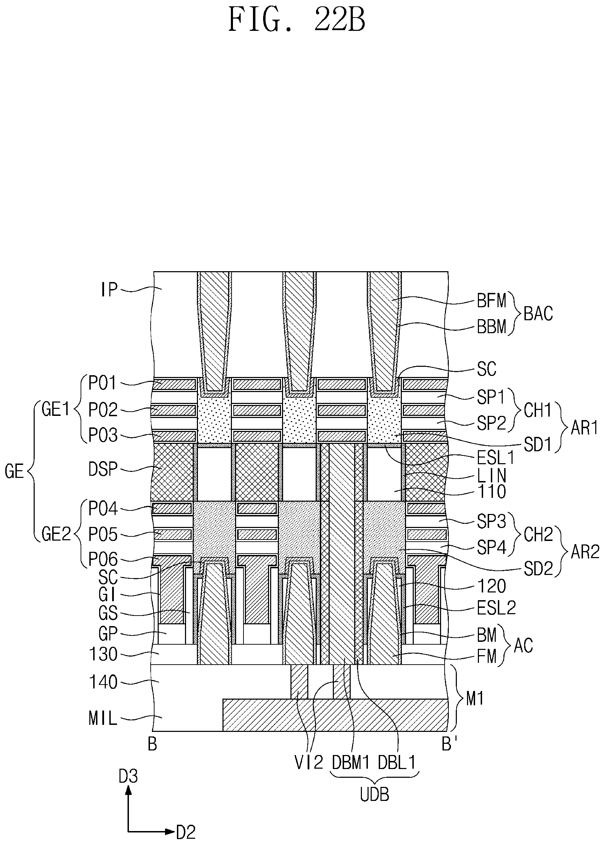

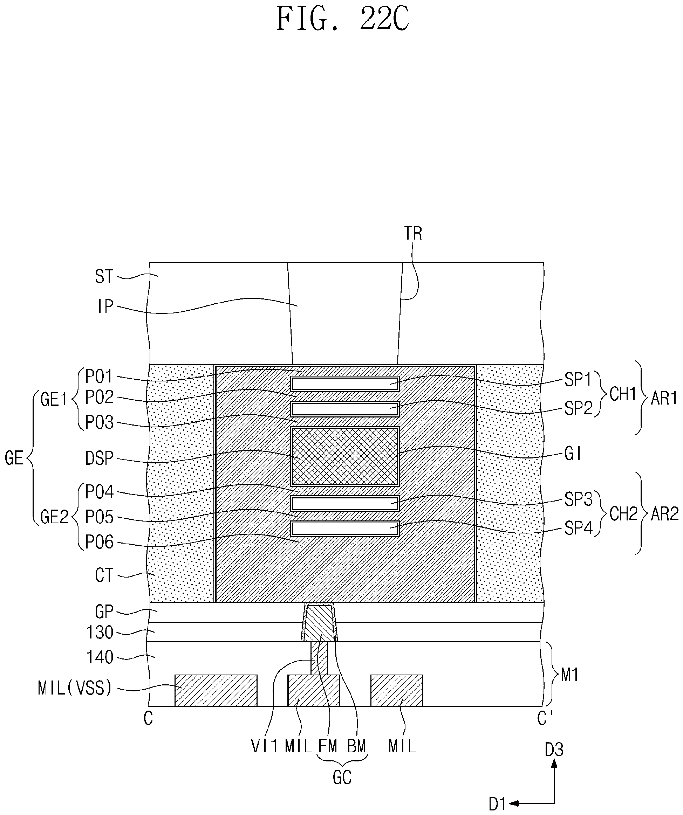

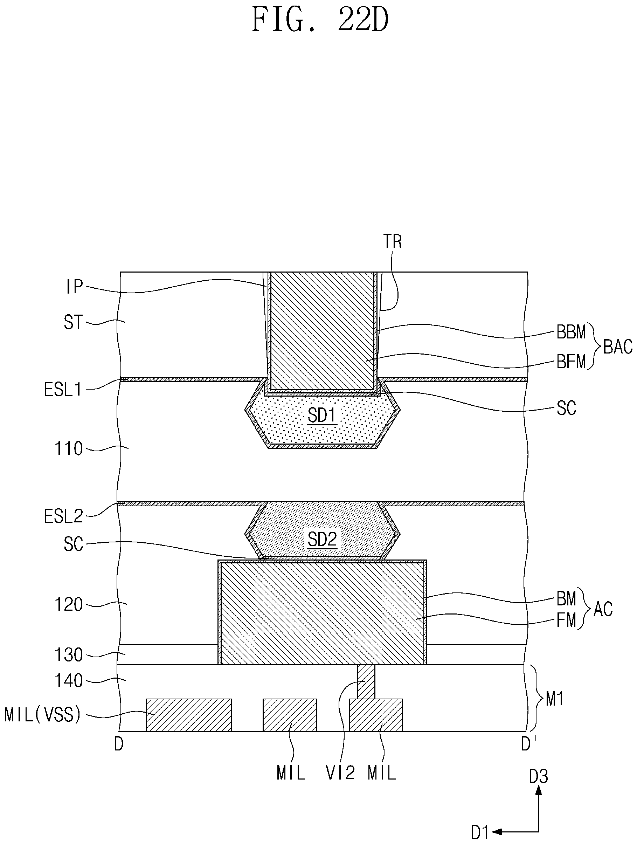

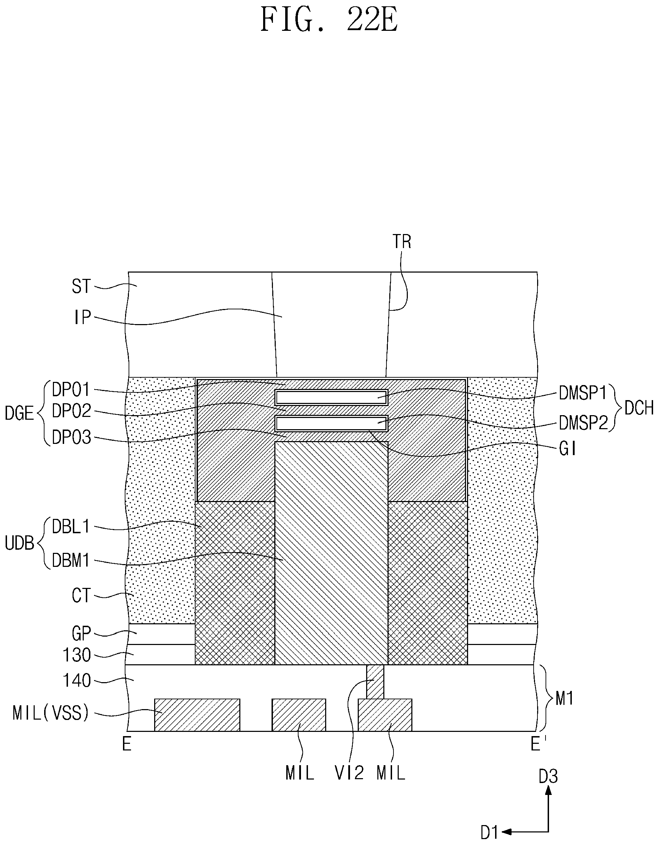

In FIGS. 22A to 22E, a cleaning process or a wet etching process may be performed to remove the residual semiconductor substrate 100, except for the device isolation layer ST including a silicon-based insulating material. After the removal of the semiconductor substrate 100, a silicon-based insulating material may be deposited to form the insulating pattern IP.

The formation of the insulating pattern IP may include removing the semiconductor substrate 100, depositing a silicon-based insulating material on a region, from which silicon is removed, and performing a planarization process on the insulating material to form the insulating pattern IP. The planarization process may be performed to expose the top surface of the device isolation layer ST.

Backside contact holes may be formed to penetrate the insulating pattern IP. The bottom active contact BAC may be formed on the first source/drain pattern SD1 exposed by the backside contact holes. The formation of the bottom active contact BAC may include forming a hard mask pattern on the insulating pattern IP and performing an etching process using the hard mask pattern.

For example, the formation of the bottom active contact BAC may include forming the bottom barrier pattern BBM and forming the bottom conductive pattern BFM on the bottom barrier pattern BBM. The metal-semiconductor compound layer SC may be further formed between the bottom active contact BAC and each of the first source/drain patterns SD1. The bottom active contact BAC may be electrically connected to the first source/drain pattern SD1. In some implementations, the bottom active contact BAC may be formed to penetrate the insulating pattern IP and may be extended into the first source/drain pattern SD1.

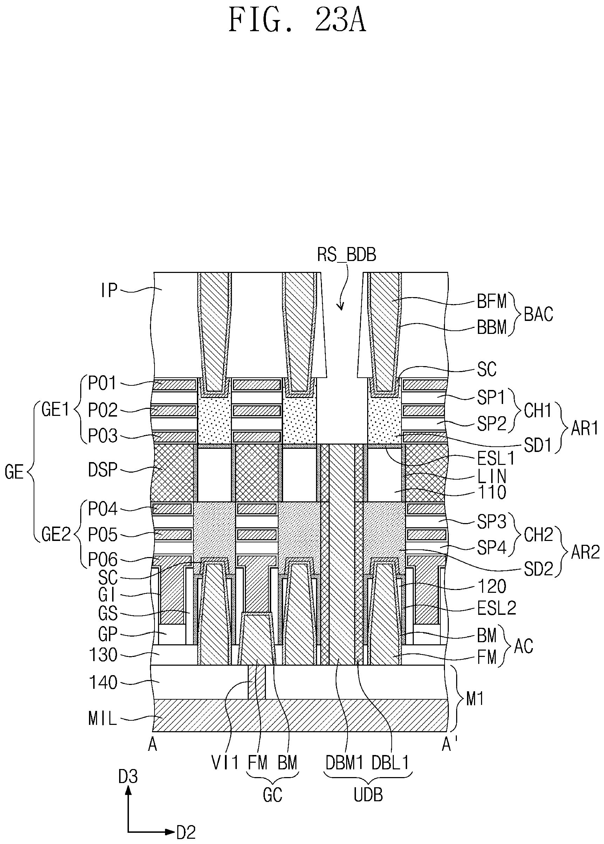

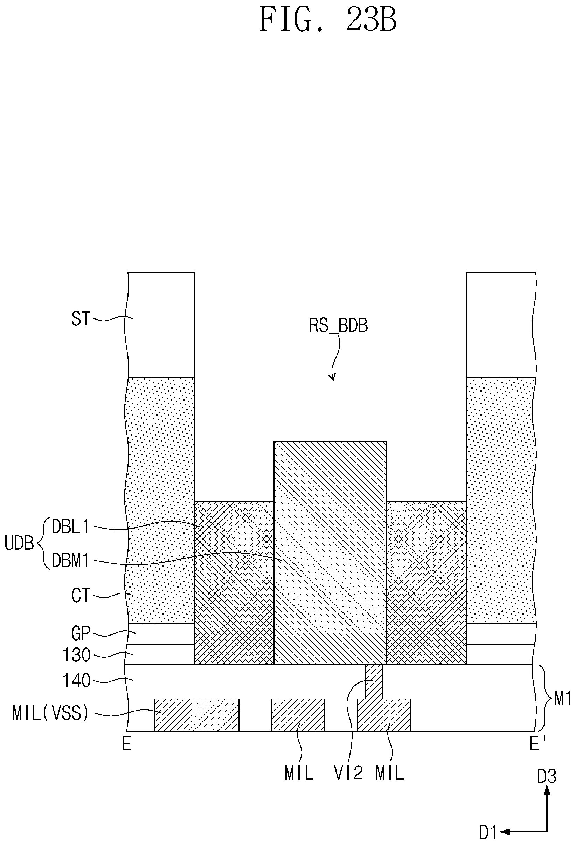

In FIGS. 23A and 23B, a hard mask pattern may be formed on the insulating pattern IP, and an etching process may be performed using the hard mask pattern. The etching process may be an anisotropic dry etching process. A lower division recess region RS_BDB may be formed, as a result of the etching process. In some implementations, the lower division recess region RS_BDB may be formed to expose a top surface of the first connection metal pattern DBM1 and side surfaces of a pair of the first source/drain patterns SD1.

For example, the lower division recess region RS_BDB may be an empty region, which is formed by removing the dummy gate electrode DGE to penetrate the device isolation layer ST and the insulating pattern IP and expose the top surface of the first connection metal pattern DBM1. A portion of a side surface of the cutting pattern CT may be exposed through the lower division recess region RS_BDB (e.g., see FIG. 23B). The exposed top surface of the first connection metal pattern DBM1 may be located at a level that is higher than the top surface of the first division liner pattern DBL1 in the third direction D3.

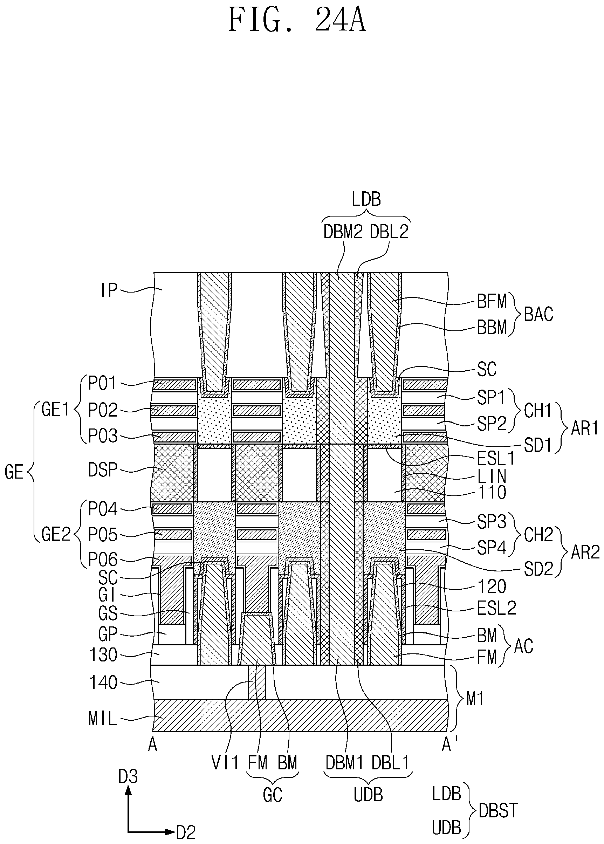

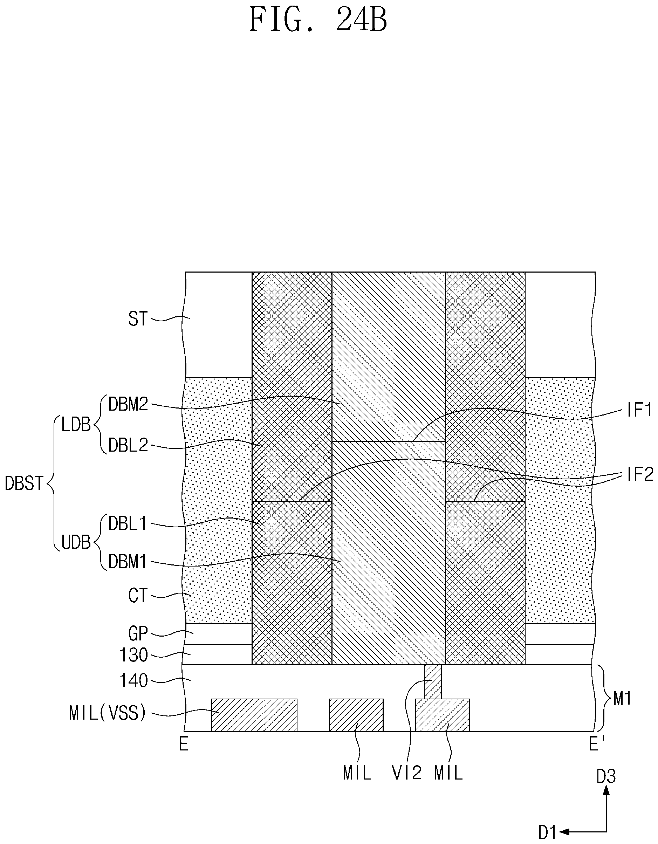

In FIGS. 24A and 24B, the lower division structure LDB may be formed on the lower division recess region RS_BDB. The formation of the lower division structure LDB may include forming the second division liner pattern DBL2 on the lower division recess region RS_BDB, performing an etching process to remove a portion of the second division liner pattern DBL2, and forming the second connection metal pattern DBM2.

The second connection metal pattern DBM2 may be in contact with the first connection metal pattern DBM1, and the second division liner pattern DBL2 may be in contact with the first division liner pattern DBL1. The first interface IF1 between the first and second connection metal patterns DBM1 and DBM2 may be located at a level that is higher than the second interface IF2 between the first and second division liner patterns DBL1 and DBL2, when measured in the third direction D3. In some implementations, at least one of the first and second interfaces IF1 and IF2 may not be observable or measurable. This is because the first and second division liner patterns DBL1 and DBL2 include the same material and the first and second connection metal patterns DBM1 and DBM2 include the same material.

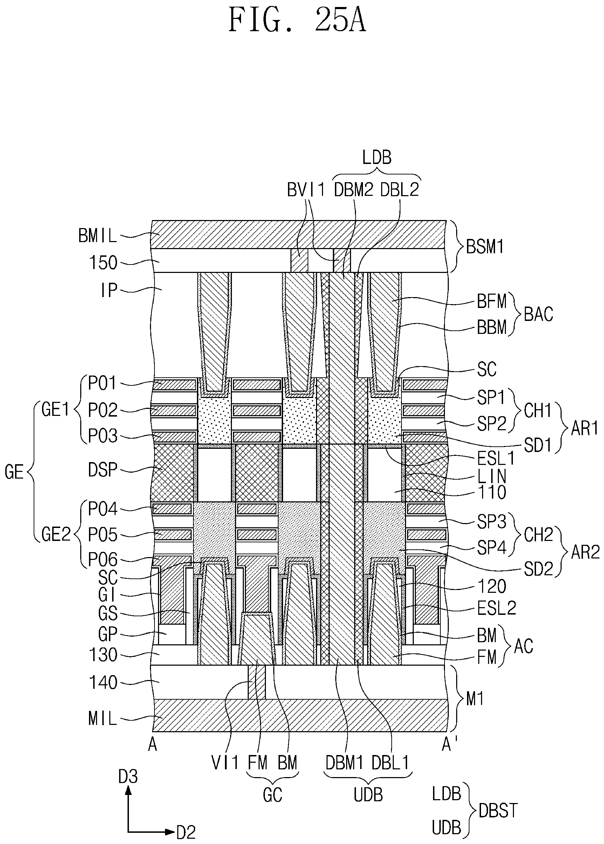

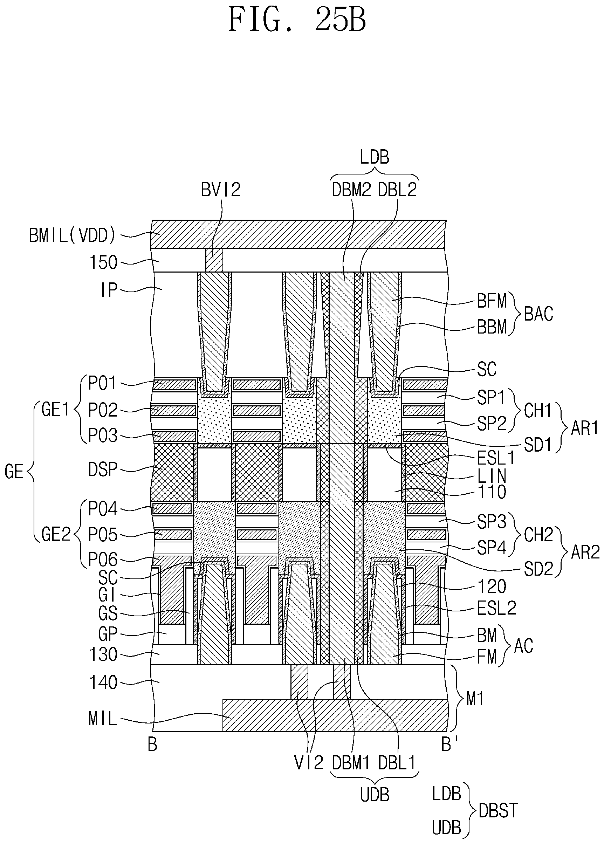

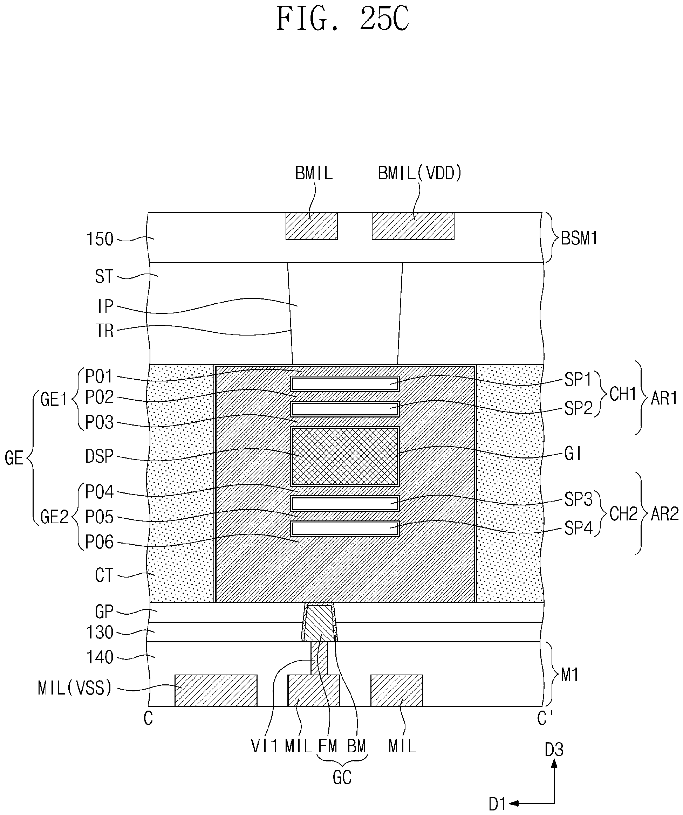

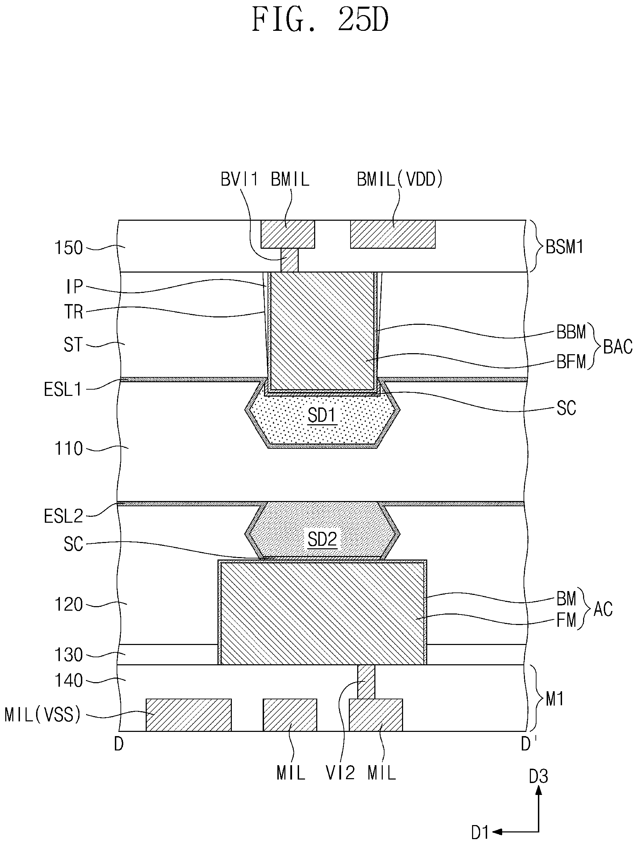

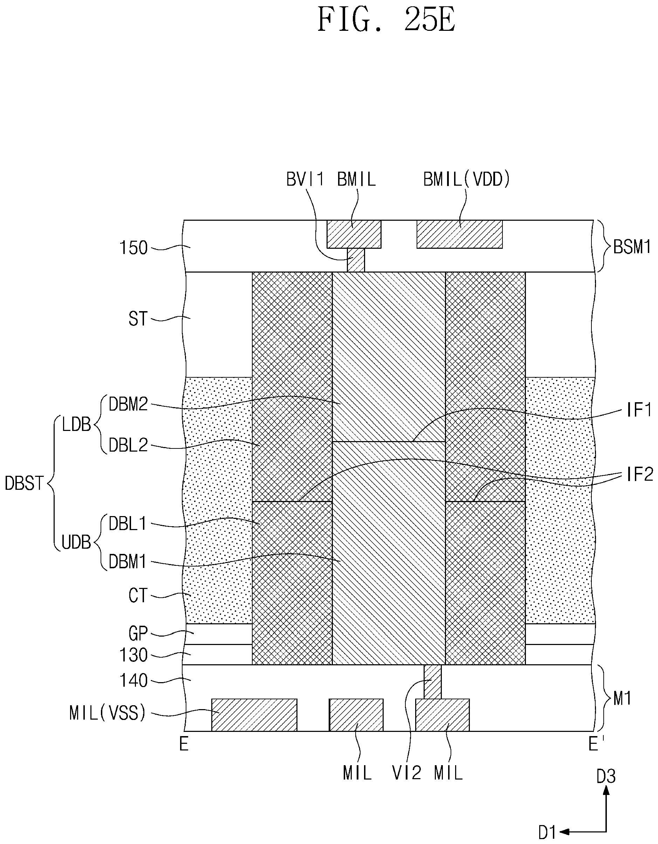

In FIGS. 25A to 25E, the fifth interlayer insulating layer 150 may be formed on the insulating pattern IP, the bottom active contacts BAC, and the lower division structure LDB. The bottom via patterns BVI1 and BVI2 and the bottom interconnection lines BMIL may be formed in the fifth interlayer insulating layer 150. The bottom via patterns BVI1 and BVI2 and the bottom interconnection lines BMIL may be defined as the lower metal layer BSM1.

For example, the lower division structure LDB may be electrically connected to the first source/drain pattern SD1 through the first bottom via patterns BVI1, the bottom interconnection lines BMIL, and the bottom active contact BAC.

In FIG. 4E or any of Figs. 25A to 25E, in the three-dimensional semiconductor device, the first and second source/drain patterns SD1 and SD2, which are vertically stacked, may be electrically connected to each other through the division structure DBST.

In a three-dimensional field effect transistor according to some implementations, source/drain regions of vertically-stacked transistors may be connected to each other through a division structure (e.g., a single diffusion break (SDB)), and in this case, it may be possible to prevent an over-head phenomenon caused by a connection pattern for connecting the source/drain regions. In other words, an effective area of a logic cell may be reduced, and thus, an integration density of a three-dimensional semiconductor device may be increased.

In a three-dimensional field effect transistor according to some implementations, it may be possible to reduce a parasitic capacitance between a gate electrode and the division structure. Accordingly, the three-dimensional semiconductor device may have improved reliability.

Embodiments are set out in the following clauses:
Clause 1. A three-dimensional semiconductor device, comprising:
   a first active region on a substrate, the first active region comprising a first channel pattern and a first source/drain pattern connected to the first channel pattern;
   a second active region stacked on the first active region, the second active region comprising a second channel pattern and a second source/drain pattern connected to the second channel pattern;
   a gate electrode on the first channel pattern and the second channel pattern;
   a bottom active contact electrically connected to the first source/drain pattern, the bottom active contact having a bar shape extending from the first source/drain pattern in a first direction;
   a lower metal layer provided below the bottom active contact, the lower metal layer comprising bottom via patterns and bottom interconnection lines that are electrically connected to the bottom active contact; and
   a division structure electrically connected to at least one of the bottom via patterns,
   wherein the division structure comprises a division liner pattern and a connection metal pattern that extends into the division liner pattern.
Clause 2. The three-dimensional semiconductor device of clause **1,** further comprising:
   an upper active contact electrically connected to the second source/drain pattern, the upper active contact having a bar shape extending from the second source/drain pattern in the first direction; and
   a first metal layer on the upper active contact, the first metal layer comprising upper via patterns and upper interconnection lines that are electrically connected to the upper active contact,
   wherein the division structure is electrically connected to at least one of the upper via patterns.
Clause 3. The three-dimensional semiconductor device of clause 1 or 2,
   wherein the division liner pattern comprises a first division liner pattern and a second division liner pattern,
   wherein the connection metal pattern comprises a first connection metal pattern and a second connection metal pattern,
   wherein the division structure comprises:
      a lower division structure; and
      an upper division structure on the lower division structure,
      wherein the upper division structure comprises the first division liner pattern and a first connection metal pattern that extends into the first division liner pattern, and
      wherein the lower division structure comprises the second division liner pattern and a second connection metal pattern that extends into the second division liner pattern.
Clause 4. The three-dimensional semiconductor device of clause 3, wherein the first division liner pattern has a first thickness that is constant in a second direction crossing the first direction.
Clause 5. The three-dimensional semiconductor device of clause 3 or 4,
   wherein the second division liner pattern comprises a first portion adjacent to the first source/drain pattern and a second portion disposed below the first portion,
   wherein the first portion has a second thickness that is constant in a second direction crossing the first direction, and
   wherein the second portion has a third thickness that increases as a distance to the lower metal layer decreases in the second direction.
Clause 6. The three-dimensional semiconductor device of any one of clauses 3 to 6,
   wherein the first division liner pattern has a first thickness in a second direction crossing the first direction,
   wherein the second division liner pattern comprises a first portion adjacent to the first source/drain pattern and a second portion disposed below the first portion,
   wherein the first portion has a second thickness in the second direction,
   wherein the second portion has a third thickness in the second direction, and
   wherein the second thickness is larger than the first thickness and the third thickness.
Clause 7. The three-dimensional semiconductor device of clause 6, wherein a largest value of the third thickness is equal to the first thickness.
Clause 8. The three-dimensional semiconductor device of any one of clauses 3 to 7,
   wherein the first division liner pattern and the second division liner pattern comprise an insulating material, and
   wherein the first connection metal pattern and the second connection metal pattern comprise a metallic material.
Clause 9. The three-dimensional semiconductor device of clause 8,
   wherein the insulating material comprises at least one of silicon oxide, silicon nitride, or silicon oxynitride, and
   wherein the metallic material comprises at least one of aluminum, copper, tungsten, molybdenum, or cobalt.
Clause 10. A three-dimensional semiconductor device optionally according to any preceding claim, the device comprising:
   a substrate including an insulating pattern defined by a device isolation layer;
   a division structure extended in a first direction crossing the insulating pattern;
   a lower metal layer provided below the substrate, the lower metal layer comprising a bottom via pattern and a bottom interconnection line; and
   a first metal layer on the division structure, the first metal layer comprising an upper via pattern and an upper interconnection line,
   wherein the division structure comprises:
      a connection metal pattern; and
      a division liner pattern provided on a side surface of the connection metal pattern and enclosing the connection metal pattern,
   wherein the bottom interconnection line, the bottom via pattern, the connection metal pattern, the upper via pattern, and the upper interconnection line are electrically connected to each other.
Clause 11. The three-dimensional semiconductor device of clause 10, further comprising a cutting pattern provided on the device isolation layer and on opposite side surfaces of the division structure.
Clause 12. The three-dimensional semiconductor device of clause 10 or **11,** wherein the division structure comprises a lower division structure and an upper division structure on the lower division structure.
Clause 13. The three-dimensional semiconductor device of any one of clauses 10 to 12,
   wherein the connection metal pattern comprises molybdenum or cobalt, and
   wherein the division liner pattern comprises silicon nitride.
Clause 14. A three-dimensional semiconductor device optionally according to any preceding claim, the device comprising:
   a first active region on a substrate, the first active region comprising a first channel pattern and a first source/drain pattern connected to the first channel pattern;
   a dummy region stacked on the first active region, the dummy region comprising a dummy pattern on the first channel pattern and an interlayer insulating layer on the first source/drain pattern;
   a second active region stacked on the dummy region, the second active region comprising a second channel pattern and a second source/drain pattern connected to the second channel pattern;
   a gate electrode on the first channel pattern and the second channel pattern;
   a bottom active contact electrically connected to the first source/drain pattern;
   a lower metal layer provided below the bottom active contact, the lower metal layer comprising bottom via patterns and bottom interconnection lines that are electrically connected to the bottom active contact;
   an upper active contact electrically connected to the second source/drain pattern; and
   a division structure electrically connected to at least one of the bottom via patterns,
   wherein the division structure comprises a division liner pattern and a connection metal pattern that extends into the division liner pattern, and
   wherein the connection metal pattern is in direct contact with the first source/drain pattern and the second source/drain pattern.
Clause 15. The three-dimensional semiconductor device of clause 14,
   wherein the division liner pattern comprises a first division liner pattern and a second division liner pattern,
   wherein the connection metal pattern comprises a first connection metal pattern and a second connection metal pattern,
   wherein the division structure comprises:
      a lower division structure; and
      an upper division structure on the lower division structure,
   wherein the upper division structure comprises the first division liner pattern and a first connection metal pattern that extends into the first division liner pattern, and
   wherein the lower division structure comprises the second division liner pattern and a second connection metal pattern that extends into the second division liner pattern.

While this disclosure contains many specific implementation details, these should not be construed as limitations on the scope of what may be claimed, equivalents thereof, as well as claims to be described later. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination. The invention is defined by the claims.

## Claims

1. A three-dimensional semiconductor device, comprising:
a first active region on a substrate, the first active region comprising a first channel pattern and a first source/drain pattern connected to the first channel pattern;
a second active region stacked on the first active region, the second active region comprising a second channel pattern and a second source/drain pattern connected to the second channel pattern;
a gate electrode on the first channel pattern and the second channel pattern;
a bottom active contact electrically connected to the first source/drain pattern, the bottom active contact having a bar shape extending from the first source/drain pattern in a first direction;
a lower metal layer provided below the bottom active contact, the lower metal layer comprising bottom via patterns and bottom interconnection lines that are electrically connected to the bottom active contact; and
a division structure electrically connected to at least one of the bottom via patterns,
wherein the division structure comprises a division liner pattern and a connection metal pattern that extends into the division liner pattern.

2. The three-dimensional semiconductor device of claim 1, further comprising:
an upper active contact electrically connected to the second source/drain pattern, the upper active contact having a bar shape extending from the second source/drain pattern in the first direction; and
a first metal layer on the upper active contact, the first metal layer comprising upper via patterns and upper interconnection lines that are electrically connected to the upper active contact,
wherein the division structure is electrically connected to at least one of the upper via patterns.

3. The three-dimensional semiconductor device of claim 1 or 2,
wherein the division liner pattern comprises a first division liner pattern and a second division liner pattern,
wherein the connection metal pattern comprises a first connection metal pattern and a second connection metal pattern,
wherein the division structure comprises:
a lower division structure; and
an upper division structure on the lower division structure,
wherein the upper division structure comprises the first division liner pattern and a first connection metal pattern that extends into the first division liner pattern, and
wherein the lower division structure comprises the second division liner pattern and a second connection metal pattern that extends into the second division liner pattern.

4. The three-dimensional semiconductor device of claim 3, wherein the first division liner pattern has a first thickness that is constant in a second direction crossing the first direction.

5. The three-dimensional semiconductor device of claim 3 or 4,
wherein the second division liner pattern comprises a first portion adjacent to the first source/drain pattern and a second portion disposed below the first portion,
wherein the first portion has a second thickness that is constant in a second direction crossing the first direction, and
wherein the second portion has a third thickness that increases as a distance to the lower metal layer decreases in the second direction.

6. The three-dimensional semiconductor device of any one of claims 3 to 5,
wherein the first division liner pattern has a first thickness in a second direction crossing the first direction,
wherein the second division liner pattern comprises a first portion adjacent to the first source/drain pattern and a second portion disposed below the first portion,
wherein the first portion has a second thickness in the second direction,
wherein the second portion has a third thickness in the second direction, and
wherein the second thickness is larger than the first thickness and the third thickness.

7. The three-dimensional semiconductor device of claim 6, wherein a largest value of the third thickness is equal to the first thickness.

8. The three-dimensional semiconductor device of any one of claims 3 to 7,
wherein the first division liner pattern and the second division liner pattern comprise an insulating material, and
wherein the first connection metal pattern and the second connection metal pattern comprise a metallic material.

9. The three-dimensional semiconductor device of claim 8,
wherein the insulating material comprises at least one of silicon oxide, silicon nitride, or silicon oxynitride, and
wherein the metallic material comprises at least one of aluminum, copper, tungsten, molybdenum, or cobalt.

10. A three-dimensional semiconductor device according to any preceding claim, comprising:
a substrate including an insulating pattern defined by a device isolation layer;
a division structure extended in a first direction crossing the insulating pattern;
a lower metal layer provided below the substrate, the lower metal layer comprising a bottom via pattern and a bottom interconnection line; and
a first metal layer on the division structure, the first metal layer comprising an upper via pattern and an upper interconnection line,
wherein the division structure comprises:
a connection metal pattern; and
a division liner pattern provided on a side surface of the connection metal pattern and enclosing the connection metal pattern,
wherein the bottom interconnection line, the bottom via pattern, the connection metal pattern, the upper via pattern, and the upper interconnection line are electrically connected to each other.

11. The three-dimensional semiconductor device of claim 10, further comprising a cutting pattern provided on the device isolation layer and on opposite side surfaces of the division structure.

12. The three-dimensional semiconductor device of claim 10, wherein the division structure comprises a lower division structure and an upper division structure on the lower division structure.

13. The three-dimensional semiconductor device of claim 10 or **11,**
wherein the connection metal pattern comprises molybdenum or cobalt, and
wherein the division liner pattern comprises silicon nitride.

14. A three-dimensional semiconductor device according to any preceding claim, comprising:
a first active region on a substrate, the first active region comprising a first channel pattern and a first source/drain pattern connected to the first channel pattern;
a dummy region stacked on the first active region, the dummy region comprising a dummy pattern on the first channel pattern and an interlayer insulating layer on the first source/drain pattern;
a second active region stacked on the dummy region, the second active region comprising a second channel pattern and a second source/drain pattern connected to the second channel pattern;
a gate electrode on the first channel pattern and the second channel pattern;
a bottom active contact electrically connected to the first source/drain pattern;
a lower metal layer provided below the bottom active contact, the lower metal layer comprising bottom via patterns and bottom interconnection lines that are electrically connected to the bottom active contact;
an upper active contact electrically connected to the second source/drain pattern; and
a division structure electrically connected to at least one of the bottom via patterns,
wherein the division structure comprises a division liner pattern and a connection metal pattern that extends into the division liner pattern, and
wherein the connection metal pattern is in direct contact with the first source/drain pattern and the second source/drain pattern.

15. The three-dimensional semiconductor device of claim 14,
wherein the division liner pattern comprises a first division liner pattern and a second division liner pattern,
wherein the connection metal pattern comprises a first connection metal pattern and a second connection metal pattern,
wherein the division structure comprises:
a lower division structure; and
an upper division structure on the lower division structure,
wherein the upper division structure comprises the first division liner pattern and a first connection metal pattern that extends into the first division liner pattern, and
wherein the lower division structure comprises the second division liner pattern and a second connection metal pattern that extends into the second division liner pattern.
